(19) **Europäisches Patentamt**
**European Patent Office**
**Office européen des brevets**

(11) **EP 4 548 114 B1**

(12) **FASCICULE DE BREVET EUROPEEN**

(45) Date de publication et mention
de la délivrance du brevet:
**17.06.2026   Bulletin 2026/25**

(21) Numéro de dépôt: **23733785.2**

(22) Date de dépôt: **28.06.2023**

(51) Classification Internationale des Brevets (IPC):
*G01R 33/28* *(2006.01)*     *G01R 33/421* *(2006.01)*
*G01R 33/56* *(2006.01)*

(52) Classification Coopérative des Brevets (CPC):
**G01R 33/282;** G01R 33/421; G01R 33/5601

(86) Numéro de dépôt international:
**PCT/EP2023/067667**

(87) Numéro de publication internationale:
**WO 2024/003147 (04.01.2024 Gazette 2024/01)**

(54) **PROCÉDÉ ET DISPOSITIF D'HYPERPOLARISATION**

VERFAHREN UND VORRICHTUNG ZUR HYPERPOLARISATION

METHOD AND DEVICE FOR HYPERPOLARISATION

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité:   **29.06.2022   FR 2206579**

(43) Date de publication de la demande:
**07.05.2025   Bulletin 2025/19**

(73) Titulaires:
• **Université Claude Bernard Lyon 1**
  **69622 Villeurbanne Cedex (FR)**
• **Centre National de la Recherche Scientifique**
  **75016 Paris (FR)**
• **Ecole Normale Supérieure de Lyon**
  **69007 Lyon (FR)**

(72) Inventeurs:
• **JANNIN, Sami**
  **1026 Echandens (CH)**
• **IVANOV, Konstantin**
  **décédé (FR)**
• **STERN, Quentin**
  **Evanston, IL 60202 (US)**
• **CEILLIER, Morgan**
  **34070 Montpellier (FR)**

• **ELLIOTT, Stuart**
  **Leytonstone E11 3BJ (GB)**

(74) Mandataire: **IPAZ**
  **16, rue Gaillon**
  **75002 Paris (FR)**

(56) Documents cités:
**WO-A1-2013/153101     WO-A2-2022/018514
FR-A- 1 401 706**

• **IVANOV KONSTANTIN L. ET AL: "The role of level
anti-crossings in nuclear spin
hyperpolarization", PROGRESS IN NUCLEAR
MAGNETIC RESONANCE SPECTROSCOPY., vol.
81, 24 June 2014 (2014-06-24), GB, pages 1 - 36,
XP093029986, ISSN: 0079-6565, DOI: 10.1016/
j.pnmrs.2014.06.001**
• **SCHROEDER W ET AL: "A spin flipper for
reversal of polarisation in a thermal atomic
beam", JOURNAL OF PHYSICS E. SCIENTIFIC
INSTRUMENTS, IOP PUBLISHING, BRISTOL, GB,
vol. 16, no. 1, 1983, pages 52 - 56, XP020017006,
ISSN: 0022-3735, DOI: 10.1088/0022-3735/16/1/
011**

## Description

### Domaine technique

La présente invention concerne une chambre d'inversion, un dispositif d'hyperpolarisation comprenant une telle chambre, et un procédé mis en œuvre par un tel dispositif.

Un tel dispositif permet à un utilisateur d'hyperpolariser une solution de manière simple et rapide. Le domaine de l'invention est plus particulièrement, mais de manière non limitative, celui des solutions hyperpolarisées pour l'imagerie médicale.

### Etat de la technique antérieure

On connait des procédés de polarisation nucléaire dynamique (DNP), tels que par exemple décrits dans WO200826937 de GE HEALTHCARE AS.

La production de métabolites au $^{13}$C hyperpolarisé permet de nouvelles applications en imagerie par résonance magnétique (IRM).

Le $^{13}$C-pyruvate hyperpolarisé est utilisé dans des applications en imagerie par résonance magnétique (IRM). Il peut être obtenu par polarisation nucléaire dynamique par dissolution (dDNP). La méthode la plus courante utilise le radical trityl comme agent polarisant pour polariser directement le $^{13}$C. Il est possible de préparer du $^{13}$C hyperpolarisé pour l'IRM avec le SpinLab (GE Healthcare) en utilisant le radical trityl. Avec le radical trityl, le temps de préparation de l'échantillon hyperpolarisé est supérieur à 60 min.

Il est également possible de polariser des noyaux de $^{1}$H et de transférer la polarisation au $^{13}$C à l'état solide par polarisation croisée (« cross polarization »). Cette méthode est rapide (moins de 20 min), mais repose sur une instrumentation très complexe. WO2013153101 de BRUKER BIOSPIN AG décrit un tel procédé.

L'article Konstantin I. et al., "The role of level anti-crossings in nuclear spin hyperpolarization", Progress in Nuclear Magnetic Resonance Spectroscopy, vol. 81, 24 juin 2024, pages 1-36, traite de l'hyperpolarisation des spins nucléaires. Dans ce cas, les spins sont polarisés par variation d'un champ magnétique.

Le but de la présente invention est de proposer un dispositif ou procédé d'hyperpolarisation à la fois rapide et simple à mettre en œuvre, cumulant ainsi deux avantages techniques que l'état de l'art n'arrive pas à cumuler, ainsi qu'une chambre pour un tel dispositif ou procédé d'hyperpolarisation.

### Exposé de l'invention

Cet objectif est atteint avec un procédé d'hyperpolarisation, comprenant une fourniture d'une solution à l'état liquide comprenant :

> o un premier type de spins nucléaires ayant un premier rapport gyromagnétique et hyperpolarisés et
> o un deuxième type de spins nucléaires ayant un deuxième rapport gyromagnétique;

la solution étant fournie à une chambre d'inversion de sorte que cette solution s'écoule selon un flux de solution dans un conduit dont une portion appelée portion d'inversion traverse la chambre d'inversion ;
la chambre d'inversion comprenant une entrée par laquelle entre le flux de solution et une sortie par laquelle sort le flux de solution ;
la chambre d'inversion comprenant de préférence un écran magnétique entourant la portion d'inversion de manière à isoler la portion d'inversion des champs magnétiques ambiants autour de l'écran magnétique;

le procédé comprenant en outre :

- une création, par au moins un moyen d'aimantation (de préférence situé au moins en partie à l'intérieur de l'écran magnétique), dit au moins un moyen d'aimantation interne, d'un champ magnétique d'inversion dont la principale composante est selon une direction Z et s'inverse en parcourant l'intérieur de la portion d'inversion de manière à transférer, au sein de la portion d'inversion, l'hyperpolarisation du premier type de spins nucléaires vers le deuxième type de spins nucléaires lors de l'écoulement du flux de solution avec une vitesse non nulle dans la portion d'inversion de l'entrée de la chambre jusqu'à la sortie de la chambre.

Les spins nucléaires des deux types de spins nucléaires sont de préférence, dans une ou plusieurs molécules de la solution, couplés par un couplage de spins scalaire.

La portion d'inversion peut être rectiligne.

L'au moins un moyen d'aimantation interne peut comprendre, au moins en partie à l'intérieur de l'écran magnétique, une paire de moyens d'aimantation internes entourant ou encadrant ou longeant au moins en partie la portion d'inversion. Chaque moyen d'aimantation interne :

- peut produire un champ magnétique constant dans le temps et opposé au champ de l'autre moyen d'aimantation interne, la somme des champs de ces deux moyens d'aimantations internes s'inversant au sein, de préférence au centre, de la portion d'inversion, et/ou
- peut comprendre ou être un solénoïde interne, l'au moins un moyen d'aimantation interne comprenant ainsi, au moins en partie à l'intérieur de l'écran magnétique, une paire de solénoïdes internes :

  o de préférence alimentés par des courants de sens de rotation opposés et/ou
  o de préférence dont les champs de fuite s'opposent.

L'au moins un moyen d'aimantation interne peut comprendre, au moins en partie à l'intérieur de l'écran magnétique, plusieurs solénoïdes internes, entourant au moins en partie la portion d'inversion et reliés par des ponts diviseurs de courant, les solénoïdes internes étant séparés en deux ensembles de solénoïdes internes :

- alimentés par des courants de sens de rotation opposés et/ou
- dont les champs de fuite s'opposent.

De préférence, il n'y a pas d'espace de séparation entre les deux ensembles de solénoïdes internes.
Les ponts diviseurs de courant peuvent comprendre des résistances variables par une interface de réglage, le procédé selon l'invention comprenant de préférence une variation des résistances des ponts diviseurs via cette interface de manière à régler ou optimiser le profil d'inversion de champ magnétique d'inversion.
Le procédé selon l'invention peut comprendre une utilisation d'un moyen d'aimantation, dit moyen d'aimantation externe d'entrée, au moins en partie à l'extérieur de l'écran magnétique et allant au moins jusqu'à l'entrée de la chambre d'inversion et un moyen d'aimantation, dit moyen d'aimantation externe de sortie, au moins en partie à l'extérieur de l'écran magnétique et allant au moins jusqu'à la sortie de la chambre d'inversion, chaque moyen d'aimantation externe maintenant dans le conduit un champ magnétique d'entrée à l'entrée de la chambre d'inversion et un champ magnétique de sortie à la sortie de la chambre d'inversion.
De préférence, chaque moyen d'aimantation externe entoure ou encadre ou longe au moins une partie de l'au moins un moyen d'aimantation interne.
De préférence :

- un moyen d'aimantation amont entoure le conduit de manière continue entre :

  o une zone qui est à la fois à l'extérieur de l'écran magnétique et à l'extérieur du moyen d'aimantation externe d'entrée, et
  o une zone qui est à la fois à l'extérieur de l'écran magnétique et à l'intérieur du moyen d'aimantation externe d'entrée, et/ou

- un moyen d'aimantation aval entoure le conduit de manière continue entre :

  o une zone qui est à la fois à l'extérieur de l'écran magnétique et à l'extérieur du moyen d'aimantation externe de sortie, et
  o une zone qui est à la fois à l'extérieur de l'écran magnétique et à l'intérieur du moyen d'aimantation externe de sortie.

Chaque moyen d'aimantation externe respectivement d'entrée ou de sortie peut entourer ou encadrer ou longer une zone de jonction entre :

- une partie du conduit pénétrant dans le moyen d'aimantation externe respectivement d'entrée ou de sortie en étant entouré par le moyen d'aimantation respectivement amont ou aval, et
- une partie du conduit entourée ou encadrée ou longée par l'au moins un moyen d'aimantation interne et pénétrant dans l'écran magnétique respectivement par l'entrée ou la sortie de la chambre d'inversion.

Chaque moyen d'aimantation externe peut comprendre ou être un solénoïde externe.
Chaque moyen d'aimantation externe peut comprendre ou être un solénoïde externe, chaque solénoïde externe étant de préférence porté autour du conduit, en entourant le conduit, par l'intermédiaire d'une pièce de support externe qui :

- du côté du conduit , n'est pas en contact du conduit, et/ou
- du côté de chaque solénoïde externe , comprend des reliefs agencés pour accueillir et positionner les spires de chaque solénoïdes externes.

L'au moins un moyen d'aimantation interne peut être au moins un solénoïde interne.

L'au moins un moyen d'aimantation interne peut être au moins un solénoïde interne, chaque solénoïde interne étant porté au moins en partie par la portion d'inversion , en entourant au moins en partie la portion d'inversion, par l'intermédiaire d'une pièce de support interne qui :

- du côté du conduit, est en contact du conduit, et/ou
- du côté de chaque solénoïde interne, comprend des reliefs agencés pour accueillir et positionner les spires de chaque solénoïde interne le long du conduit.

Le procédé selon l'invention peut comprendre en outre une fourniture de la solution, après son passage dans la chambre d'inversion, à un spectromètre à résonance magnétique nucléaire (RMN) ou à un dispositif d'imagerie par résonance magnétique (IRM) par le conduit.

Le champ magnétique d'inversion peut avoir, dans la portion d'inversion, une seule composante qui est selon la direction Z et qui s'inverse en parcourant la portion d'inversion.

La fourniture de la solution à la chambre d'inversion peut comprendre une fourniture de la solution en provenance d'un dispositif de DNP (Polarisation dynamique nucléaire ) relié au conduit, et/ou en provenance de tout autre dispositif capable de fabriquer et/ou fournir une solution comprenant les deux types de spins.

La portion d'inversion et/ou le conduit est de préférence un capillaire dont la plus grande dimension, perpendiculairement au flux de solution, est inférieure à 5 mm.

Dans la portion d'inversion, le champ magnétique d'inversion est de préférence compris, en valeur absolue le long de la direction Z, au moins entre 0 mT et 0,1 mT .

Le premier type de spins nucléaires peut avoir un plus fort rapport gyromagnétique que le deuxième type de spins nucléaires.

Suivant encore un autre aspect de l'invention, il est proposé une chambre d'inversion, comprenant :

- une entrée agencée pour qu'un flux d'une solution à l'état liquide comprenant :

    o un premier type de spins nucléaires ayant un premier rapport gyromagnétique et hyperpolarisés et
    o un deuxième type de spins nucléaires ayant un deuxième rapport gyromagnétique,

    entre dans la chambre par cette entrée;

- une sortie agencée pour que le flux de solution sorte de la chambre par cette sortie

l'entrée et la sortie étant agencées pour que cette solution s'écoule selon le flux de solution dans un conduit dont une portion appelée portion d'inversion traverse la chambre d'inversion ;
la chambre comprenant en outre :

- de préférence un écran magnétique entourant la portion d'inversion de manière à isoler la portion d'inversion des champs magnétiques ambiants autour de l'écran magnétique;
- au moins un moyen d'aimantation (de préférence situé au moins en partie à l'intérieur de l'écran magnétique), dit au moins un moyen d'aimantation interne, agencé pour créer un champ magnétique d'inversion dont la principale composante est selon une direction Z et s'inverse en parcourant l'intérieur de la portion d'inversion de manière à transférer, au sein de la portion d'inversion, l'hyperpolarisation du premier type de spins nucléaires vers le deuxième type de spins nucléaires lors de l'écoulement du flux de solution avec une vitesse non nulle dans la portion d'inversion de l'entrée de la chambre jusqu'à la sortie de la chambre.

Les spins nucléaires des deux types de spins nucléaires sont de préférence, dans une ou plusieurs molécules de la solution, couplés par un couplage de spins scalaire.

La portion d'inversion peut être rectiligne.

L'au moins un moyen d'aimantation interne peut comprendre, au moins en partie à l'intérieur de l'écran magnétique, une paire de moyens d'aimantation internes entourant ou encadrant ou longeant au moins en partie la portion d'inversion. Chaque moyen d'aimantation interne :

- peut être agencé pour produire un champ magnétique constant dans le temps et opposé au champ de l'autre moyen d'aimantation interne, de sorte que la somme des champs de ces deux moyens d'aimantations internes s'inverse au sein, de préférence au centre, de la portion d'inversion, et/ou
- peut comprendre ou être un solénoïde interne, l'au moins un moyen d'aimantation interne comprenant ainsi, au moins en partie à l'intérieur de l'écran magnétique, une paire de solénoïdes internes, avec de préférence :

  o la chambre pouvant comprendre en outre une alimentation agencée pour alimenter les deux solénoïdes internes par des courants de sens de rotation opposés, et/ou
  o les champs de fuite des deux solénoïdes internes qui s'opposent.

L'au moins un moyen d'aimantation interne peut comprendre, au moins en partie à l'intérieur de l'écran magnétique, plusieurs solénoïdes internes, entourant au moins en partie la portion d'inversion et reliés par des ponts diviseurs de courant, les solénoïdes internes étant séparés en deux ensembles de solénoïdes internes, la chambre comprenant en outre une alimentation agencée pour alimenter les deux ensembles de solénoïdes internes :

- par des courants de sens de rotation opposés, et/ou
- de sorte que les champs de fuite des deux ensembles de solénoïdes internes s'opposent.

La chambre d'inversion selon l'invention peut ne pas comprendre d'espace de séparation entre les deux ensembles de solénoïdes internes.

Les ponts diviseurs de courant peuvent comprendre des résistances variables par une interface de réglage, ladite interface de réglage étant agencée pour faire varier des résistances des ponts diviseurs via cette interface de manière à régler ou optimiser le profil d'inversion de champ magnétique d'inversion.

La chambre d'inversion selon l'invention peut comprendre en outre un moyen d'aimantation, dit moyen d'aimantation externe d'entrée, au moins en partie à l'extérieur de l'écran magnétique et allant au moins jusqu'à l'entrée de la chambre d'inversion et un moyen d'aimantation, dit moyen d'aimantation externe de sortie, au moins en partie à l'extérieur de l'écran magnétique et allant au moins jusqu'à la sortie de la chambre d'inversion, chaque moyen d'aimantation externe étant agencé pour maintenir dans le conduit un champ magnétique d'entrée à l'entrée de la chambre d'inversion et un champ magnétique de sortie à la sortie de la chambre d'inversion.

Chaque moyen d'aimantation externe peut entourer ou encadrer ou longer au moins une partie de l'au moins un moyen d'aimantation interne.

La chambre d'inversion selon l'invention peut comprendre en outre :

- un moyen d'aimantation amont qui entoure le conduit de manière continue entre :

  o une zone qui est à la fois à l'extérieur de l'écran magnétique et à l'extérieur du moyen d'aimantation externe d'entrée, et
  o une zone qui est à la fois à l'extérieur de l'écran magnétique et à l'intérieur du moyen d'aimantation externe d'entrée, et/ou

- un moyen d'aimantation aval qui entoure le conduit de manière continue entre :

  o une zone qui est à la fois à l'extérieur de l'écran magnétique et à l'extérieur du moyen d'aimantation externe de sortie, et
  o une zone qui est à la fois à l'extérieur de l'écran magnétique et à l'intérieur du moyen d'aimantation externe de sortie.

Chaque moyen d'aimantation externe respectivement d'entrée ou de sortie peut entourer ou encadrer ou longer une zone de jonction entre :

- une partie du conduit pénétrant dans le moyen d'aimantation externe respectivement d'entrée ou de sortie en étant entouré par le moyen d'aimantation respectivement amont ou aval, et
- une partie du conduit entourée ou encadrée ou longée par l'au moins un moyen d'aimantation interne et pénétrant dans l'écran magnétique respectivement par l'entrée ou la sortie de la chambre d'inversion .

Chaque moyen d'aimantation externe peut comprendre ou être un solénoïde externe.

Chaque solénoïde externe peut être porté autour du conduit, en entourant le conduit, par l'intermédiaire d'une pièce de support externe qui :

- du côté du conduit, n'est pas en contact du conduit, et/ou
- du côté de chaque solénoïde externe, comprend des reliefs agencés pour accueillir et positionner les spires de chaque solénoïdes externes.

L'au moins un moyen d'aimantation interne peut être au moins un solénoïde interne.

Chaque solénoïde interne peut être porté au moins en partie par la portion d'inversion, en entourant au moins en partie la portion d'inversion, par l'intermédiaire d'une pièce de support interne qui :

- du côté du conduit, est en contact du conduit, et/ou
- du côté de chaque solénoïde interne, comprend des reliefs agencés pour accueillir et positionner les spires de chaque solénoïde interne le long du conduit.

La chambre d'inversion selon l'invention peut être agencée pour que le champ magnétique d'inversion a, dans la portion d'inversion, une seule composante qui est selon la direction Z et qui s'inverse en parcourant la portion d'inversion.

La portion d'inversion et/ou le conduit peut être un capillaire dont la plus grande dimension, perpendiculairement au flux de solution, est inférieure à 5 mm.

La chambre d'inversion selon l'invention peut être agencée pour que, dans la portion d'inversion, le champ magnétique d'inversion est compris, en valeur absolue le long de la direction Z, au moins entre 0 mT et 0,1 mT.

Le premier type de spins nucléaires peut avoir un plus fort rapport gyromagnétique que le deuxième type de spins nucléaires.

Suivant encore un autre aspect de l'invention, il est proposé un dispositif d'hyperpolarisation, comprenant :

- Une chambre d'inversion selon l'invention,
- Un dispositif agencé pour fournir la solution à l'entrée de la chambre d'inversion par le conduit.

Le dispositif selon l'invention peut comprendre en outre un spectromètre à résonance magnétique nucléaire (RMN) ou un dispositif d'imagerie par résonance magnétique (IRM) relié à la sortie de la chambre d'inversion par le conduit

Le dispositif agencé pour fournir la solution peut comprendre :

- un dispositif de Polarisation dynamique nucléaire DNP relié au conduit, et/ou

- tout autre dispositif capable de fabriquer et/ou fournir une solution comprenant les deux types de spins.

**Description des figures et modes de réalisation**

D'autres avantages et particularités de l'invention apparaîtront à la lecture de la description détaillée de mises en œuvre et de modes de réalisation nullement limitatifs, et des dessins annexés suivants :

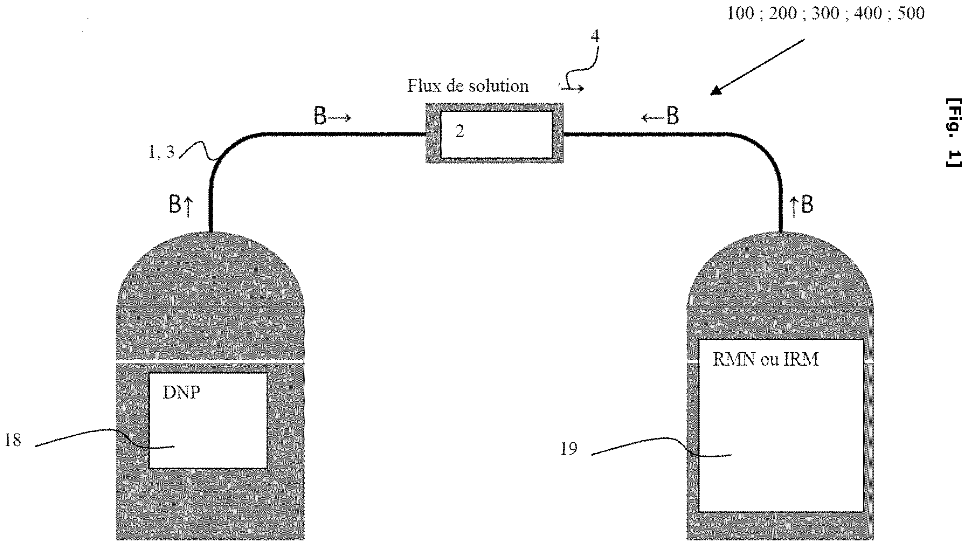

**[Fig. 1]** la figure 1 illustre les caractéristiques communes de différents modes de réalisation 100, 200, 300, 400, 500 de dispositifs d'hyperpolarisation selon l'invention se distinguant par le mode de réalisation de chambre d'inversion 2 compris dans le dispositif respectivement 100, 200, 300, 400, ou 500,

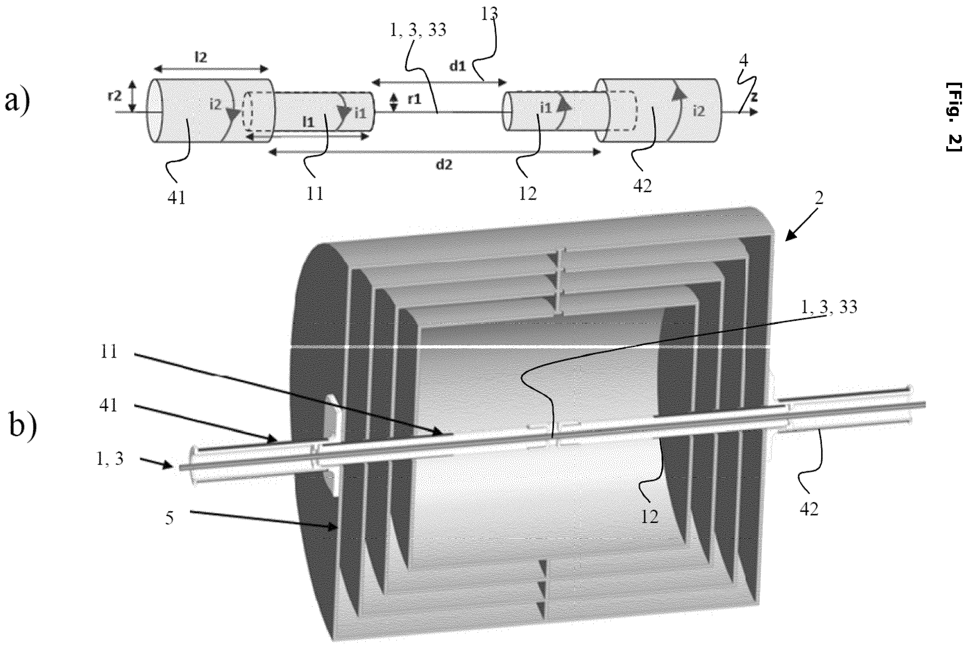

**[Fig. 2]** la figure 2 illustre, sur ses parties a) et b) un premier mode de réalisation de chambre d'inversion 2 selon l'invention du premier mode de réalisation de dispositif d'hyperpolarisation 100 selon l'invention, la partie a) étant une vue schématique de principe, la partie b) étant une vue de coupe en perspective,

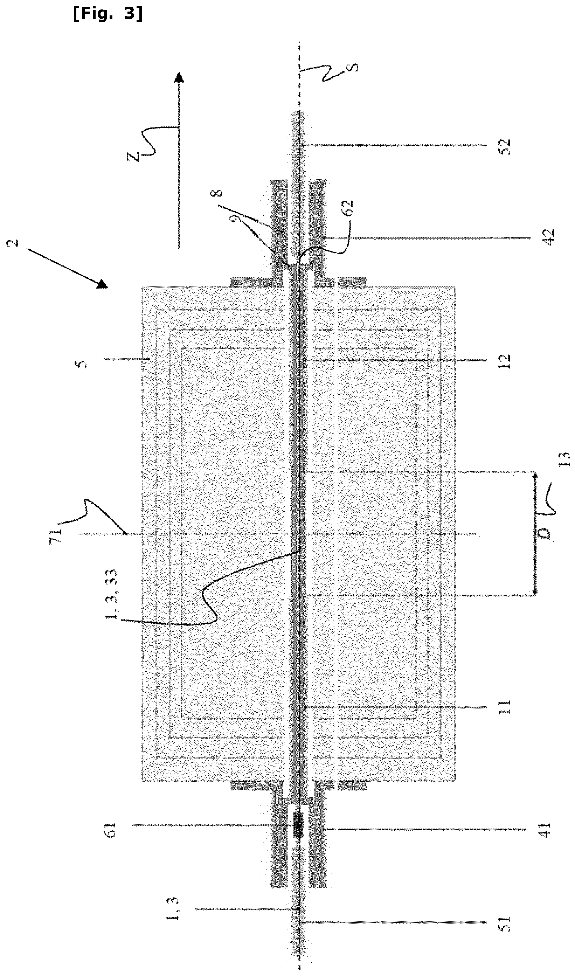

**[Fig. 3]** la figure 3 illustre une vue de coupe de profil du premier mode de réalisation de chambre d'inversion 2 selon l'invention du premier mode de réalisation de dispositif d'hyperpolarisation 100 selon l'invention,

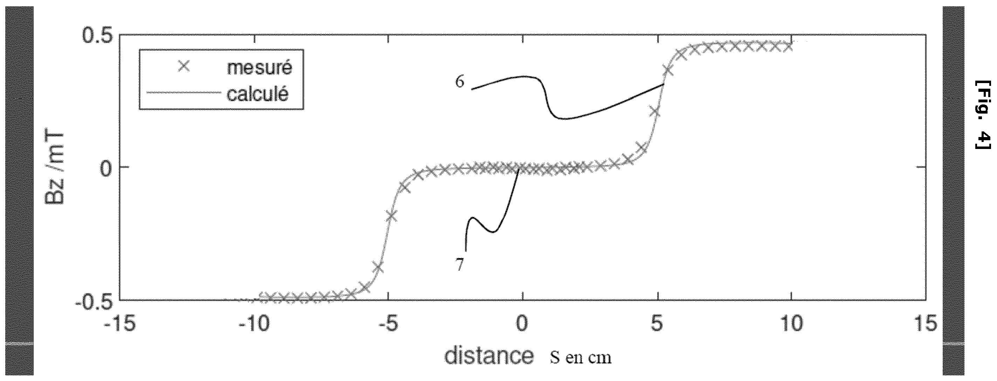

**[Fig. 4]** la figure 4 illustre le profil du champ magnétique d'inversion 6 généré dans le premier mode de réalisation de chambre d'inversion 2 selon l'invention du premier mode de réalisation de dispositif d'hyperpolarisation 100 selon l'invention, avec en abscisse la position en cm le long de l'axe S de la portion 33, et en ordonnée la valeur du champ magnétique d'inversion 6 (en mT) le long de la direction Z, et où l'axe S est parallèle à la direction Z ; Le champ 6 a été mesuré à l'aide d'un teslamètre et comparé avec le champ prédit par les équations d'un solénoïde idéal ; la position 0 correspond au centre de la chambre 2 (milieu de l'écran magnétique 5) ; pour cette figure, le courant électrique utilisé dans les solénoïdes 11 et 12 pour mesurer le champ à l'aide d'un teslamètre est plus élevé que le courant nécessaire pour une utilisation de l'invention pour un transfert de polarisation.

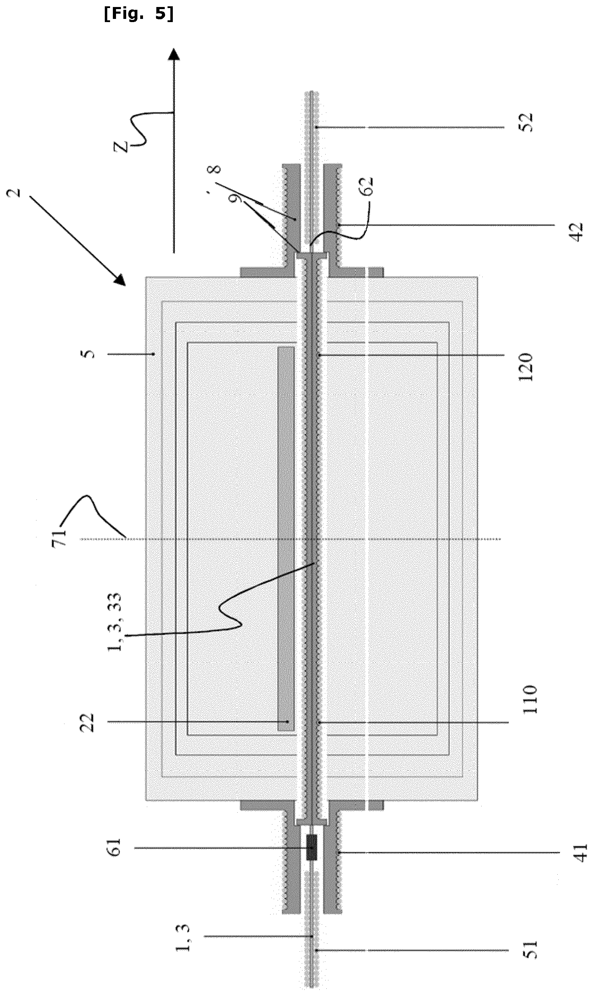

**[Fig. 5]** la figure 5 illustre une vue de coupe de profil d'un deuxième mode de réalisation de chambre d'inversion 2 selon l'invention du deuxième mode de réalisation de dispositif d'hyperpolarisation 200 selon l'invention, qui sont les modes de réalisation préférés de chambre 2 et de dispositif 200 de l'invention,

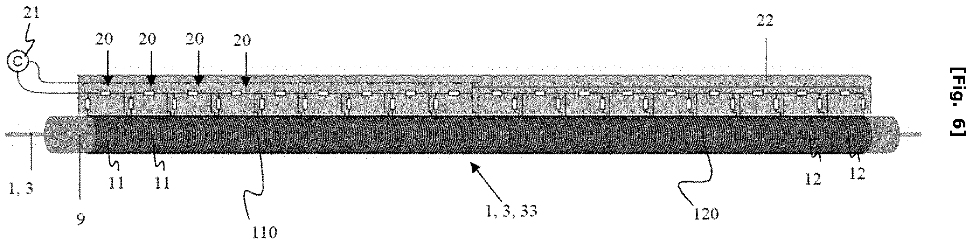

**[Fig. 6]** la figure 6 illustre des détails internes du deuxième mode de réalisation de chambre d'inversion 2 selon l'invention du deuxième mode de réalisation de dispositif d'hyperpolarisation 200 selon l'invention, notamment ses ponts diviseurs de courant 20 et leur alimentation électrique,

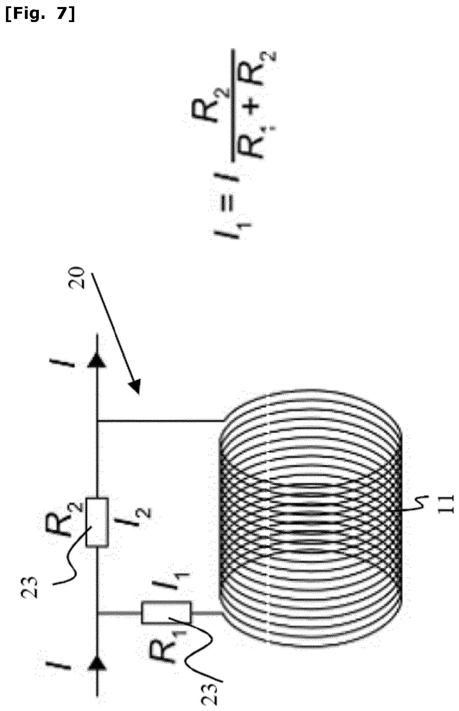

**[Fig. 7]** la figure 7 illustre des détails internes du deuxième mode de réalisation de chambre d'inversion 2 selon l'invention du deuxième mode de réalisation de dispositif d'hyperpolarisation 200 selon l'invention, notamment un des solénoïdes internes 11 ou 12 et son pont diviseur de courant 20 et ses résistances 23,

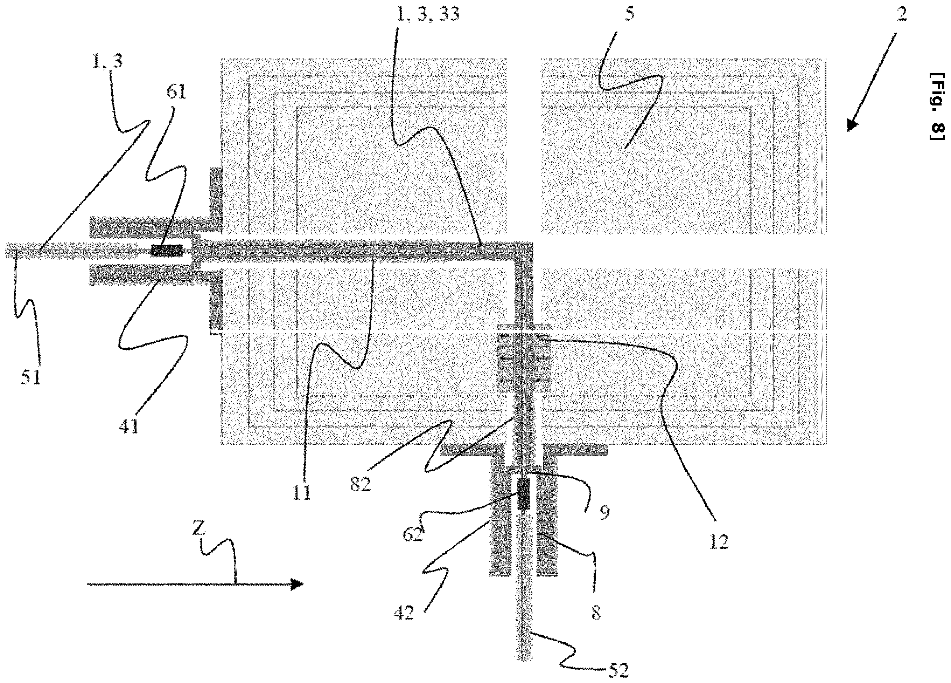

**[Fig. 8]** la figure 8 illustre une vue de coupe de profil d'un troisième mode de réalisation de chambre d'inversion 2 selon l'invention du troisième mode de réalisation de dispositif d'hyperpolarisation 300 selon l'invention,

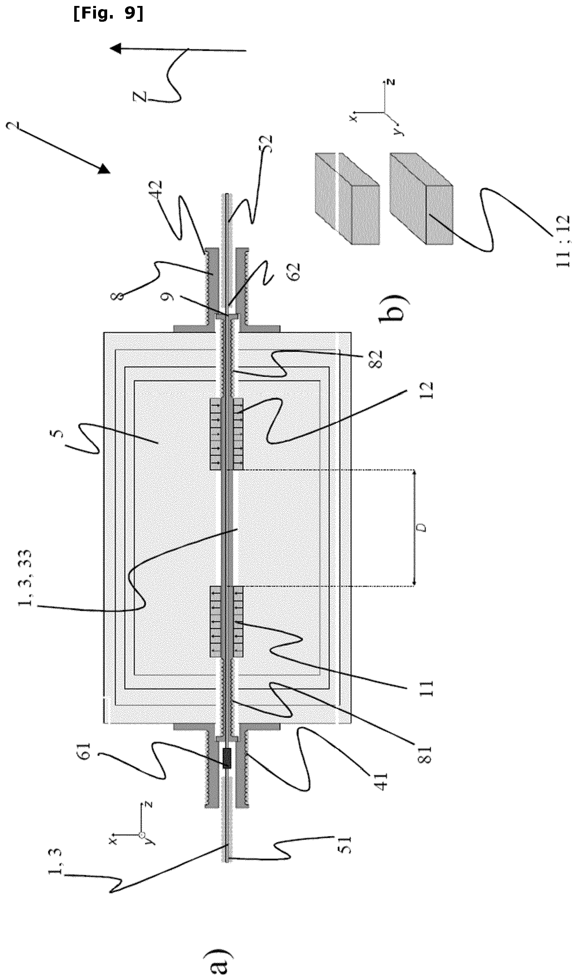

**[Fig. 9]** la figure 9 illustre sur sa partie a) une vue de coupe de profil d'un quatrième mode de réalisation de chambre d'inversion 2 selon l'invention du quatrième mode de réalisation de dispositif d'hyperpolarisation 400 selon l'invention, et sur sa partie b) une vue en perspective de ses moyens d'aimantation 11 ou 12,

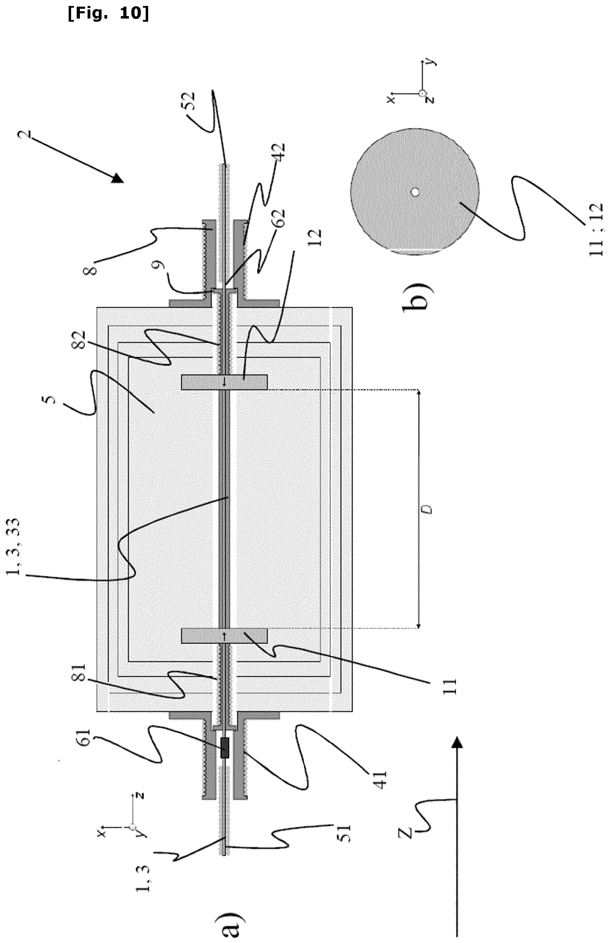

**[Fig. 10]** la figure 10 illustre sur sa partie a) une vue de coupe de profil d'un cinquième mode de réalisation de chambre d'inversion 2 selon l'invention du cinquième mode de réalisation de dispositif d'hyperpolarisation 500 selon l'invention, et sur sa partie b) une vue de face (perpendiculairement au plan de sa partie a)) de ses moyens d'aimantation 11 ou 12.

Ces modes de réalisation étant nullement limitatifs, on pourra notamment considérer des variantes de l'invention ne comprenant qu'une sélection de caractéristiques décrites ou illustrées par la suite isolées des autres caractéristiques décrites ou illustrées (même si cette sélection est isolée au sein d'une phrase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, et/ou avec seulement une partie des détails structurels si cette partie uniquement est suffisante pour conférer un avantage technique ou à différencier l'invention par rapport à l'état de la technique antérieure.

On va tout d'abord décrire, en référence aux figures 1 à 4, le premier mode de réalisation de dispositif d'hyperpolarisation 100 selon l'invention comprenant le premier mode de réalisation de chambre d'inversion 2 selon l'invention.

Le dispositif 100 comprend une chambre d'inversion 2, comprenant :

- une entrée agencée pour qu'un flux d'une solution 1 à l'état liquide comprenant :

    o un premier type de spins nucléaires ayant un premier rapport gyromagnétique et hyperpolarisés (de préférence $^1$H, qui a pour avantage d'être très rapidement hyperpolarisé en amont de la chambre 2 par DNP) et

    o un deuxième type de spins nucléaires ayant un deuxième rapport gyromagnétique (de préférence $^{13}$C, qui a pour avantage d'avoir un plus long temps de relaxation que les spins nucléaires $^1$H), les spins nucléaires des deux types étant, dans une ou plusieurs molécules de la solution 1, couplés par un couplage de spins scalaire,

    entre dans la chambre 2 par cette entrée;

- une sortie agencée pour que le flux de solution 1 sorte de la chambre 2 par cette sortie

l'entrée et la sortie étant agencées pour que cette solution 1 s'écoule selon le flux de solution dans un conduit 3 dont une portion appelée portion d'inversion 33 traverse la chambre d'inversion 2.

Par « spin » ou « spin nucléaire », on entend dans la présente description un spin d'un noyau atomique (éventuellement au sein d'une molécule), porté par un noyau atomique.

La chambre 2 comprend en outre un écran magnétique 5 entourant la portion d'inversion 33 agencée pour isoler la portion d'inversion 33 des champs magnétiques ambiants autour de l'écran magnétique 5.

Comme illustré en figure 2a et 3, cet écran 5 comprend de préférence plusieurs couches (de préférence concentriques) pour une meilleure efficacité.

L'entrée de la chambre 2 correspond à l'entrée du conduit 3 dans l'écran 5 depuis l'extérieur de la chambre 2.

La sortie de la chambre 2 correspond à la sortie du conduit 3 hors de l'écran 5 depuis l'intérieur de la chambre 2.

La chambre 2 comprend en outre au moins un moyen d'aimantation 11, 12 situé au moins en partie à l'intérieur de l'écran magnétique 5, dit au moins un moyen d'aimantation interne 11, 12, et entourant ou encadrant ou longeant au moins une partie de la portion d'inversion 33. L'au moins un moyen d'aimantation interne 11, 12 est agencé pour créer, dans la portion 33, un champ magnétique d'inversion 6 dont la principale composante est selon une direction Z et s'inverse (au niveau d'un plan d'inversion 71) de préférence une unique fois en parcourant (le long de l'axe S et de la direction Z) l'intérieur de la portion d'inversion 33 de l'entrée à la sortie de la chambre 2, de manière à transférer, au sein de la portion d'inversion 33, l'hyperpolarisation du premier type de spins nucléaires vers le deuxième type de spins nucléaires lors de l'écoulement du flux de solution 1 dans la portion d'inversion 33 sans immobiliser la solution 1 dans la portion d'inversion 33, i.e. avec une vitesse non nulle de la solution 1 dans la portion d'inversion 33 de l'entrée de la chambre jusqu'à la sortie de la chambre.

Par s'inverser, on entend dans la présente description pour la composante principale changer de sens (tout en gardant la même direction Z).

Par champ magnétique d'inversion 6 dont la principale composante est selon une direction Z , on entend de préférence dans la présente description que si le champ 6 à une composante transverse à la composante principale, cette composante transverse reste toujours inférieure :

- à 10% de la composante principale selon la direction Z qui s'inverse, et/ou
- à 1 $\mu$T (par exemple si le couplage scalaire est de l'ordre de 100-200 Hz pour une paire $^1$H-$^{13}$C), voir même toujours inférieur à 0,1 $\mu$T (par exemple pour un couplage de 10-20 Hz), le champ transverse maximal permettant un transfert efficace diminuant linéairement avec l'intensité du couplage scalaire entre les spins nucléaires en tout point de la solution 1 dans la portion 33.

La chambre 2 est agencée pour que le champ magnétique d'inversion 6 a, dans la portion d'inversion 33, de préférence une seule composante qui est uniquement selon la direction Z (i.e. avec une composante perpendiculaire à Z nulle ou négligeable par rapport à la composante principale) et qui s'inverse en parcourant la portion d'inversion 33.

L'au moins un moyen d'aimantation interne 11, 12 comprend :

- du côté de l'entrée de la chambre 2, au moins un moyen d'aimantation interne d'entrée 11,
- du côté de la sortie de la chambre 2, au moins un moyen d'aimantation interne de sortie 12.

Par moyen d'aimantation, on entend dans la présente description de préférence un électro-aimant, un aimant permanent, un assemblage de plusieurs électro-aimants, un assemblage de plusieurs aimants permanents, ou un assemblage d'électro-aimant(s) et d'aimant(s) permanent(s).

Par solénoïde, on entend dans la présente description un fil conducteur d'un électro aimant, ce fil étant enroulé en plusieurs boucles ou spires et parcouru (ou agencé pour être parcouru) par un courant électrique.

Par écran ou blindage magnétique 5 on entend dans la présente description un écran de toute forme (continue (feuille, plaque, etc.) et/ou discontinue (grille, treillis, etc.)), de préférence métallique, et agencé pour isoler l'intérieur de l'écran 5 de champs magnétiques continus temporellement ou de basse fréquence temporelle situés autour de l'écran 5, de préférence :

- agencé pour diminuer d'au moins un facteur 10$^5$ , de préférence au moins 10$^6$, la valeur en Tesla d'un champ magnétique continu temporellement et situé autour de l'écran 5 et ayant autour de l'écran 5 une valeur inférieure ou égale à 100 micro Tesla, et /ou
- ayant un facteur d'écrantage d'au moins 10$^5$, de préférence d'au moins 10$^6$.

Par solution 1, on entend dans la présente description un liquide ou un mélange de liquides, pouvant éventuellement comprendre des particules solides en suspension.

Dans ce mode de réalisation, la portion d'inversion 33 est rectiligne et s'étend longitudinalement le long d'un axe S.

Dans ce mode de réalisation, les directions S et Z sont confondues.

Dans ce mode de réalisation, l'au moins un moyen d'aimantation interne 11, 12 comprend, au moins en partie à l'intérieur de l'écran magnétique 5, une paire de moyens d'aimantation internes 11, 12 entourant ou encadrant ou longeant au moins en partie la portion d'inversion 33.

Il existe un espace de séparation 13 le long de l'axe S (et de la direction Z) entre :

- l'au moins un moyen d'aimantation interne d'entrée 11, et
- l'au moins un moyen d'aimantation interne de sortie 12.

Cela permet, dans ce mode de réalisation 100, d'avoir un flux de solution 1 plus rapide (le profil de champ 6 étant plus proche de l'idéal et on peut donc choisir une vitesse de flux plus élevée tout en gardant un transfert efficace).

Plus exactement, chaque moyen d'aimantation interne 11 et 12 comprend :

- une partie à l'intérieur de l'écran 5 et entourant ou encadrant ou longeant une partie de la portion d'inversion 33, et
- une partie à l'extérieur de l'écran 5 (mais à l'intérieur d'un des moyens d'aimantation externe 41, 42 qui sera décrit par la suite) et entourant ou encadrant ou longeant une autre partie de la portion d'inversion 33.

La portion d'inversion 33 correspond à une portion du conduit 3 entourée ou longée ou encadrée par l'au moins un moyen d'aimantation interne 11, 12.

Chaque moyen d'aimantation interne comprend un solénoïde interne, l'au moins un moyen d'aimantation interne 11, 12 comprenant ainsi, au moins en partie à l'intérieur de l'écran magnétique 5, une paire de solénoïdes internes 11, 12 antiparallèles dont les spires sont centrées sur un même axe S.

La chambre 2 comprend en outre au moins une alimentation (non illustrée, et située de préférence à l'extérieur de l'écran 5), de préférence une seule alimentation commune, agencée pour alimenter électriquement les deux solénoïdes internes 11, 12 par des courants $i_1$ (de préférence de même intensité) de sens de rotation opposés de sorte que les champs de fuite des deux solénoïdes internes 11, 12 s'opposent. Ce courant $i_1$ est constant dans le temps.

Une alimentation commune a pour avantage d'être plus simple et permet un champ d'inversion 6 plus stable.

Chaque moyen d'aimantation interne respectivement 11 ou 12 (i.e. chaque solénoïde respectivement 11 ou 12) est agencé pour produire un champ magnétique constant dans le temps.

Chaque moyen d'aimantation interne respectivement 11 ou 12 (i.e. chaque solénoïde respectivement 11 ou 12) est agencé pour produire un champ magnétique opposé au champ de l'autre moyen d'aimantation interne respectivement 12 ou 11 (i.e. de l'autre solénoïde respectivement 12 ou 11), de sorte que la somme des champs de ces deux moyens d'aimantations internes (i.e. de ces deux solénoïdes 11, 12) s'inverse au sein (dans un plan d'inversion 71 perpendiculaire à la portion 33) de la portion d'inversion 33, de préférence au centre, le long de la direction S, de la portion d'inversion 33 et de l'espace de séparation 13.

Le chambre 2 comprend en outre :

- un moyen d'aimantation, dit moyen d'aimantation externe d'entrée 41, au moins en partie à l'extérieur de l'écran magnétique 5 et allant au moins jusqu'à l'entrée de la chambre d'inversion 2 ; le moyen d'aimantation externe d'entrée 41 peut être à la fois à l'extérieur et à l'intérieur de l'écran 5, mais est de préférence uniquement à l'extérieur de l'écran 5, et
- un moyen d'aimantation, dit moyen d'aimantation externe de sortie 42, au moins en partie à l'extérieur de l'écran magnétique 5 et allant au moins jusqu'à la sortie de la chambre d'inversion 2 ; le moyen d'aimantation externe de sortie 42 peut être à la fois à l'extérieur et à l'intérieur de l'écran 5, mais est de préférence uniquement à l'extérieur de l'écran 5.

Chaque moyen d'aimantation externe 41 ou 42 est agencé pour maintenir dans le conduit 3 un champ magnétique d'entrée (constant dans le temps) à l'entrée de la chambre d'inversion 2 et un champ magnétique de sortie (constant dans le temps) à la sortie de la chambre d'inversion 2.

Chacun parmi le champ magnétique d'entrée et le champ magnétique de sortie est typiquement d'au moins 4 mT selon la direction Z qui est sa direction principale.

Chacun parmi le champ magnétique d'entrée et le champ magnétique de sortie permet que la polarisation n'est pas perdue à cause de la rotation du champ non adiabatique (due par exemple à l'effet sommé du champ ambiant et de l'écran magnétique 5).

Chaque moyen d'aimantation externe 41, 42 entoure ou encadre ou longe au moins une partie de l'au moins un moyen d'aimantation interne 11, 12 à l'intérieur ou à l'extérieur de l'écran 5, de préférence au moins à l'extérieur de l'écran 5, de préférence uniquement à l'extérieur de l'écran 5.

Le moyen d'aimantation externe d'entrée 41 entoure ou encadre ou longe une partie, située à l'extérieur de l'écran, du solénoïde 11.

Le moyen d'aimantation externe de sortie 42 entoure ou encadre ou longe une partie, située à l'extérieur de l'écran, du solénoïde 12.

Le dispositif 100 comprend en outre :

- un moyen d'aimantation ou solénoïde amont 51 qui entoure le conduit 3 de manière continue entre :

  o une zone qui est à la fois à l'extérieur de l'écran magnétique 5 et à l'extérieur du moyen d'aimantation externe d'entrée 41, et
  o une zone qui est à la fois à l'extérieur de l'écran magnétique 5 et à l'intérieur du moyen d'aimantation externe d'entrée 41, et

- un moyen d'aimantation ou solénoïde aval 52 qui entoure le conduit 3 de manière continue entre :

o une zone qui est à la fois à l'extérieur de l'écran magnétique 5 et à l'extérieur du moyen d'aimantation externe de sortie 42, et

o une zone qui est à la fois à l'extérieur de l'écran magnétique 5 et à l'intérieur du moyen d'aimantation externe de sortie 42.

Chaque moyen d'aimantation 51 ou 52 est agencé pour maintenir dans le conduit 3 un champ magnétique (constant dans le temps) respectivement en amont et en aval de la chambre 2.

Chaque moyen d'aimantation externe respectivement d'entrée 41 ou de sortie 42 entoure ou encadre ou longe une zone de jonction 61 à l'entrée de la chambre 2 ou 62 à la sortie de la chambre 2 entre :

- une partie du conduit 3 pénétrant dans le moyen d'aimantation externe respectivement d'entrée 41 ou de sortie 42 en étant entouré ou encadré ou longé par le moyen d'aimantation respectivement amont 51 ou aval 52, et
- une partie du conduit 3 entourée ou encadrée ou longée par l'au moins un moyen d'aimantation interne 11, 12 et de préférence pénétrant dans l'écran magnétique 5 respectivement par l'entrée ou la sortie de la chambre d'inversion 2.

Chaque moyen d'aimantation externe comprend ou est un solénoïde externe, la chambre 2 comprenant ainsi, au moins en partie à l'extérieur de l'écran magnétique 5, une paire de solénoïdes externes 41, 42 antiparallèles dont les spires sont de préférence centrées sur le même axe S.

La chambre 2 comprend en outre au moins une alimentation (non illustrée, et située de préférence à l'extérieur de l'écran 5), de préférence une alimentation commune, agencée pour alimenter électriquement les deux solénoïdes externes 41, 42 par des courants $i_2$ (de préférence de même intensité) de sens de rotation opposés. Le courant $i_2$ est constant dans le temps.

Le courant $i_1$ dans le solénoïde 11 tourne dans le même sens de rotation que le courant $i_2$ dans le solénoïde 41.

Le courant $i_1$ dans le solénoïde 12 tourne dans le même sens de rotation que le courant $i_2$ dans le solénoïde 42.

Une alimentation commune a pour avantage d'être plus simple et permet un champ d'inversion 6 plus stable.

Chaque solénoïde externe 41 ou 42 est porté autour du conduit 3, en entourant le conduit 3, par l'intermédiaire d'une pièce de support externe 8 qui :

- du côté du conduit 3, n'est pas en contact du conduit (mais entoure une partie seulement du solénoïde amont 51 ou aval 52, une partie seulement de l'au moins un solénoïde interne 11, 12, et la zone de jonction 61 ou 62), et
- du côté de chaque solénoïde externe 41 ou 42, comprend des reliefs (enroulés sous forme de spires autour de la pièce de support externe 8) agencés pour accueillir et positionner les spires du solénoïde externe 41 ou 42.

Comme décrit précédemment, l'au moins un moyen d'aimantation interne 11, 12 comprend au moins un solénoïde interne 11, 12.

Chaque solénoïde interne 11, 12 est porté au moins en partie par la portion d'inversion 33, en entourant au moins en partie la portion d'inversion 33, par l'intermédiaire d'une pièce de support interne 9 qui :

- du côté du conduit 3, est en contact du conduit 3, et
- du côté de chaque solénoïde interne 11, 12, comprend des reliefs (enroulés sous forme de spires autour de la pièce de support interne 9) agencés pour accueillir et positionner les spires du solénoïde interne 11 ou 12 le long du conduit 3 et en particulier le long de la portion d'inversion 33.

La portion d'inversion 33 et/ou le conduit 3 est un capillaire dont la plus grande dimension, perpendiculairement au flux de solution 1 (i.e. perpendiculairement à l'axe S), est inférieure à 5 mm. Cela permet une meilleure maitrise du champ 6, car plus on s'éloigne du centre de la portion 33 (dans un plan de coupe perpendiculaire à la portion 33) plus la composante transverse du champ 6 risque d'être importante.

La chambre 2 est agencée pour que, dans la portion d'inversion 33, le champ magnétique d'inversion 6 est compris, en valeur absolue le long de la direction Z, au moins entre 0 mT et 0,1 mT, ou même au moins entre 0 mT et 0,2 mT. Le champ 6 a, dans la portion 33, de préférence au moins une valeur supérieure à 10 fois le rapport (couplage J des deux types de spins)/(différence des rapports gyromagnétique des deux types de spins).

La chambre est agencée pour que, dans la portion d'inversion 33, le champ magnétique d'inversion 6 s'inverse au moins entre une valeur $+B_{max}$ le long de la direction Z et une valeur de sens opposé $+B_{max}$ le long de la direction Z, avec $B_{max}$ qui est égal au moins à 0,1 mT, ou au moins à 0,2 mT.

Dans le cadre d'un procédé d'utilisation du dispositif 100, le premier type de spins nucléaires a de préférence un plus fort rapport gyromagnétique que le deuxième type de spins nucléaires.

Outre la chambre 2 venant d'être décrite, le dispositif d'hyperpolarisation 100 comprend un dispositif 18 agencé pour fournir la solution 1 à l'entrée (i.e. en amont) de la chambre d'inversion 2 par le conduit 3.

Le dispositif 18 comprend :

- de préférence un dispositif 18 de Polarisation dynamique nucléaire DNP (pour « dynamic nuclear polarisation » en anglais), de préférence de Polarisation dynamique nucléaire de dissolution dDNP (pour « dissolution dynamic nuclear polarisation » en anglais) relié au conduit 3, et/ou
- tout autre dispositif 18 capable de fabriquer et/ou fournir une solution comprenant les deux types de spins nucléaires.

Le dispositif 100 comprend en outre un spectromètre à résonance magnétique nucléaire (RMN) 19 ou un dispositif d'imagerie par résonance magnétique (IRM) 19 relié à la sortie (i.e. en aval) de la chambre d'inversion 2 par le conduit 3.

Le dispositif 100 comprend en outre, en aval de la chambre 2, i.e entre la chambre 2 et le dispositif 19, des moyens de purification (non illustrés) de la solution 1, par exemple une ou plusieurs matrices polarisantes, par exemple des matrices polarisantes HYPOP pour purifier la solution 1 des traces d'agent polarisant.

Le transfert de polarisation d'un noyau vers l'autre est total s'il est adiabatique, autrement dit, s'il est suffisamment lent. Le temps minimum pour une transition adiabatique $\tau_{\text{trans}}$ peut être calculé par la théorie de Landau-Zener dans le cas simple d'une variation linéaire de l'intensité du champ magnétique 6 au cours du temps pour deux spins couplés (premier type et deuxième type de spins nucléaires de rapports gyromagnétiques différents couplés par un couplage scalaire, de préférence couplés au sein d'une même molécule) qui se déplace dans la portion 33 (le champ 6 étant constant dans le temps à chaque point fixe à l'intérieur de la portion 33) qui peut être écrit comme

[Math.1]

$$B_z(t) = B_{\max}\left(1 - 2\frac{t}{\tau_{\text{trans}}}\right),$$

où le champ 6 vaut $+B_{\max}$ au temps $t = 0$ (typiquement à l'entrée de la chambre 2) et $-B_{\max}$ au temps $t = \tau_{\text{trans}}$ (typiquement à la sortie de la chambre 2). La valeur du champ $B_{\max}$ est donnée par la condition

[Math.2]

$$B_{\max} \gg \frac{J_{IS}}{\gamma_I - \gamma_S},$$

où $J_{IS}$, $\gamma_I$ et $\gamma_S$ sont le couplage scalaire entre les spins en Hz et leur rapport gyromagnétique en Hz.T$^{-1}$. Pour obtenir une valeur numérique à cette condition, on peut choisir

[Math.3]

$$B_{\max} \approx 10\frac{J_{IS}}{\gamma_I - \gamma_S},$$

ce qui s'étend entre 0,3 et 63 $\mu$T pour une paire de spins de $^1$H et $^{13}$C avec des couplages typiques (entre 1 et 200 Hz, respectivement). La théorie de Landau-Zener montre que le temps de transfert minimum pour une transition adiabatique dans le profil de champ magnétique linéaire de $+B_{\max}$ à $-B_{\max}$ (voir équation Math.1) est donné par la condition

[Math.4]

$$\tau_{\text{trans}} \gg \frac{1}{J_{IS}}.$$

Pour obtenir une valeur numérique à cette condition, on peut choisir

[Math.5]

$$\tau_{\text{trans}} \approx 10\frac{1}{J_{IS}},$$

ce qui s'étend entre 0,05 et 10 s pour une paire de spins de $^1$H et $^{13}$C avec des couplages typiques (entre 1 et 200 Hz, respectivement).

Il est a noter que le transfert peut être considérablement réduit si un profil de champ non linéaire est adopté. Le profil d'adiabaticité constante (i.e. celui qui permet le transfert adiabatique le plus rapide possible) peut être calculé numériquement. Une paire de solénoïdes 11, 12 alignés selon un même axe S et dont les champs de fuite s'opposent permettent de s'approcher de ce profil idéal avec une distance entre les solénoïdes (distance *D* référencée 13 sur la figure 3). On peut notamment jouer sur cette distance 13 et le courant qui parcoure les solénoïdes 11, 12.

Ainsi, on peut facilement calculer et optimiser la vitesse du flux de la solution 1 dans la portion 33 et donc son temps de présence dans la portion 33 en fonction du champ 6 et des deux types de spins et de leur couplage.

Le profil du champ 6 subit par un couple de spins nucléaires couplés de la solution 1 en fonction du temps dépend :

- du profil, dans l'espace (et constant dans le temps), du champ 6 qui dépend de l'agencement des différents moyens d'aimantation interne d'entrée 11 et de sortie 12 et éventuellement du courant les parcourant s'il ne s'agit pas d'aimants permanents. Le profil de champ 6 le long de la position S peut être calculé à l'aide des équations classiques des solénoïdes idéaux, et optimisé en optimisant le courant $i_1$.
- de la vitesse du flux de solution 1, qui peux être calculé et optimisé comme précédemment expliqué et simplement réglé par une pompe ou valve ou tout autre moyen connu de réglage de la vitesse du flux de solution 1.

Ainsi, pour résumer ce mode de réalisation de l'invention :

- L'écran magnétique 5 permet d'écranter le champ magnétique terrestre et ceux produits par les appareils autour de la chambre 2,

- Les moyens d'aimantation internes 11, 12 créent l'inversion spatiale du champ 6,

- Les moyens d'aimantation externes 41, 42 servent à maintenir un champ suffisant à l'entrée et à la sortie de la chambre d'inversion 2,

- Le conduit 3 (qui est un capillaire) est lui-même est entouré d'une bobine ou moyen d'aimantation 51, 52 (enroulée et collée sur le conduit 3) pour soutenir un champ magnétique suffisant tout au long du transfert de la solution du dispositif 18 jusqu'à la chambre 2 puis de la chambre 2 jusqu'à sa destination 19.

Typiquement, le dispositif ou procédé selon l'invention utilise la dDNP pour polariser le premier type de spin $^1$H puis cette polarisation est transférée au 2$^{ème}$ type de spin $^{13}$C à l'état liquide. Dans le cas de l'invention, l'inversion se fait en déplaçant la solution 1 à travers un profil de champ 6 dans l'espace. De plus, l'invention utilise de manière fortement préférentielle la DNP ou dDNP pour préparer la solution 1 de $^1$H hyperpolarisés en amont de la chambre 2.

Le dispositif ou procédé selon l'invention, permet de produire en moins de 20 min des solutions de métabolites au $^{13}$C hyperpolarisé sans avoir recours à une instrumentation complexe, car la production d'une solution contenant des noyaux de $^1$H hyperpolarisés par DNP est plus rapide et plus simple qu'une production directe de $^{13}$C (par exemple par cross-polarization) puis le transfert dans la chambre 2 en flux continu de la polarisation de $^1$H vers $^{13}$C (ou $^{15}$N ou $^{31}$P) est très rapide, simple et sans interruption. Contrairement à la cross-polarization, ajouter une chambre d'inversion 2 selon l'invention ne demande pas de modification profonde du polariseur mais seulement d'ajouter un équipement peu couteux à la sortie du polariseur.

Typiquement, on produit rapidement (<20 min) des solutions de $^{13}$C hyperpolarisé pour des molécules où le noyau $^{13}$C est couplé à moins un noyau $^1$H. L'invention utilise un protocole courant pour produire une solution 1 dont le $^1$H est hyperpolarisé par "dissolution dynamique nuclear polarisation" (dDNP). La polarisation est ensuite transférée du $^1$H au $^{13}$C dans la solution 1 à l'état liquide en transportant la solution 1 à travers un profil de champ magnétique 6 qui s'inverse de manière contrôlée. Ce profil de champ 6 est obtenu en utilisant l'écran magnétique 5 qui annule les champs ambiants (le champ résiduel est de l'ordre du nT) munis d'une paire de bobines solénoïdes 11, 12 antiparallèles à courant constant, ou plus généralement une paire de moyens d'aimantation interne d'entrée 11 et de sortie 12 ou au moins un moyen d'aimantation interne 11, 12. Chaque bobine 11, 12 produit un champ magnétique 6 constant et opposé. Le capillaire 3, 33 traverse les solénoïdes 11, 12 et l'écran magnétique 5 si bien que, lorsque la solution 1 est poussée dans le capillaire 3, 33, les molécules ressentent une inversion du champ magnétique 6 au cours du temps. Le couplage scalaire (couplage J) entre les noyaux de $^1$H et $^{13}$C permet le transfert de polarisation. La théorie de ce transfert est bien établie et permet d'optimiser le profil de champ pour la molécule à hyperpolariser. Ce transfert "en flux", c'est-à-dire sans immobiliser la solution 1, permet un transfert rapide et minimise les pertes dues à la relaxation.

Ainsi, l'invention permet de polariser des spins nucléaires à bas rapport gyromagnétique (par exemple le $^{13}$C)

pour des applications en IRM plus rapidement ou avec une instrumentation moins complexe que les méthodes existantes.

Une expérience a été réalisée avec le dispositif selon l'invention de la figure 3 afin de polariser des spins nucléaires de $^{13}$C-formate et de $^{13}$C-pyruvate. Une forte augmentation de la polarisation de ces molécules a été observée, avec une polarisation finale de ces molécules de plusieurs pourcents mesurée par résonance magnétique liquide.

On va maintenant décrire, en référence aux figures 1 et 5 à 7, le deuxième mode de réalisation de dispositif d'hyperpolarisation 200 selon l'invention comprenant le deuxième mode de réalisation de chambre d'inversion 2 selon l'invention, et ces modes de réalisation ne seront décrits que pour leurs différences par rapport aux premiers modes de réalisation de chambre 2 et de dispositif 100 précédemment décrits.

Le dispositif 200 est plus précis que le dispositif 100.

Dans ce mode de réalisation, l'au moins un moyen d'aimantation interne 11, 12 comprend, au moins en partie à l'intérieur de l'écran magnétique 5, plusieurs solénoïdes internes 11, 12, entourant au moins en partie la portion d'inversion 33 et reliés électriquement entre eux par des ponts diviseurs de courant 20.

Les solénoïdes internes 11, 12 sont séparés en deux ensembles 110, 120 de solénoïdes internes :

- un premier ensemble 110 de solénoïdes internes d'entrée 11 tous du côté de l'entrée de la chambre 2,
- un deuxième ensemble 120 de solénoïdes internes de sortie 12, tous du côté de la sortie de la chambre 2.

Chaque paire de solénoïdes internes 11 voisins (de l'ensemble 110) est reliée électriquement par un pont 20 diviseur de courant (et que par ce pont 20), de préférence sans espace intermédiaire entre ces solénoïdes internes 11, mais sans contact électrique direct entre ces solénoïdes voisins 11 (i.e. une spire d'un solénoïde 11 ne se poursuit pas en une spire d'un autre solénoïde voisin 11).

Chaque paire de solénoïdes internes 12 voisins (de l'ensemble 120) est reliée électriquement par un pont 20 diviseur de courant (et que par ce pont 20), de préférence sans espace intermédiaire entre ces solénoïdes internes 12, mais sans contact électrique direct entre ces solénoïdes voisins 12 (i.e. une spire d'un solénoïde 12 ne se poursuit pas en une spire d'un autre solénoïde voisin 12).

Le premier ensemble 110 est relié électriquement au deuxième ensemble 120 sont connectés à la même source 21, mais avec un sens de rotation de courant électrique de chaque solénoïde 11 de l'ensemble 110 qui est opposé au sens de rotation de courant électrique de chaque solénoïde 12 de l'ensemble 120 .

L'ensemble 110 comprend autant de solénoïdes 11 que l'ensemble 120 comprend de solénoïdes 12.

La chambre 2 comprend en outre au moins une alimentation, de préférence une alimentation commune, agencée pour alimenter électriquement les deux ensembles 110, 120 de solénoïdes internes par des courants $i_1$ (de préférence de même intensité) de sens de rotation opposés de sorte que les champs de fuite des deux ensembles 110, 120 de solénoïdes internes s'opposent. $i_1$ est constant dans le temps.

Une alimentation commune a pour avantage d'être plus simple et permet un champ d'inversion 6 plus stable.

Les deux ensembles 110 et 120 sont antiparallèles.

Les spires des solénoïdes 11 et 12 sont centrées sur le même axe S

La chambre ne comprend pas d'espace de séparation entre les deux ensembles 110, 120 de solénoïdes internes 11, 12, c'est-à-dire que le premier ensemble 110 est plaqué au deuxième ensemble 120, seul un écart d'un simple jeu mécanique pouvant éventuellement subsister.

Cela permet, dans ce mode de réalisation 200, d'avoir un transfert plus rapide et donc de minimiser les pertes par relaxation pendant le transfert.

Chaque pont 20 comprend une paire de résistances 23.

Les ponts diviseurs de courant 20 comprennent des résistances variables 23 par une interface de réglage, ladite interface de réglage étant agencée pour faire varier des résistances 23 des ponts diviseurs 20 via cette interface de manière à régler ou optimiser le profil d'inversion de champ magnétique d'inversion 6.

Comme résistances réglables 23 et interface de réglage, on peut utiliser tout type de technologie de résistance variable, par exemple utiliser tout type de potentiomètre ou rhéostat commandé depuis l'extérieur de l'écran 5 par des moyens analogiques et/ou numériques, un écran tactile, etc.

Le profil spatial du champ 6 peut être affiné en réglant :

- le courant $i_1$ dans chaque solénoïde 11 et/ou 12, et/ou

- les valeurs (égales ou différentes) des différentes résistances 23.

Même sans le réglage des résistances 23, le dispositif 200 est plus précis que le dispositif 100.

Toutes les résistances 23 de l'ensemble des ponts 20 sont montées sur un unique circuit imprimé qui est par exemple intégré à l'intérieur de l'écran 5.

Le moyen d'aimantation externe d'entrée 41 entoure ou encadre ou longe une partie, située à l'extérieur de l'écran, de l'ensemble 110.

Le moyen d'aimantation externe de sortie 42 entoure ou encadre ou longe une partie, située à l'extérieur de l'écran, de l'ensemble 120.

La chambre 2 du dispositif 200 correspond donc à la chambre 2 du dispositif 100 dans laquelle :

- le solénoïde 11 du dispositif 100 est remplacé par l'ensemble 110 et ses ponts 20 du dispositif 200

- le solénoïde 12 du dispositif 100 est remplacé par l'ensemble 120 et ses ponts 20 du dispositif 200.

Dans une variante du mode de réalisation des figures 5 à 7 :

- la portion 33 a une forme de V, l'inversion du champ 6 se produisant à la pointe du V, la pointe du V délimitant la séparation entre les deux ensembles 110 et 120, et/ou
- il existe une séparation entre les ensembles 110 et 120, même si cela est moins favorable.

Les deux modes de réalisation des figures 1 à 7 venant d'être décrits peuvent être généralisés en remplaçant le terme « solénoïde » par « moyen d'aimantation » (ou « électro-aimant », « aimant permanent », « assemblage de plusieurs électro-aimants », « assemblage de plusieurs aimants permanents », ou « assemblage d'électro-aimant(s) et d'aimant(s) permanent(s) »). En cas d'aimant(s) permanent(s), les moyens d'alimentations électriques précédemment décrits des solénoïdes ne sont plus nécessaires.

On va maintenant décrire, en référence aux figures 1 et 8, le troisième mode de réalisation de dispositif d'hyperpolarisation 300 selon l'invention comprenant le troisième mode de réalisation de chambre d'inversion 2 selon l'invention, et ces modes de réalisation ne seront décrits que pour leurs différences par rapport aux premiers mode de réalisation de chambre 2 et de dispositif 100 précédemment décrits.

Dans ce mode de réalisation, la portion d'inversion 33 n'est pas rectiligne.

Dans ce mode de réalisation, une première et une deuxième parties de la portion d'inversion 33 forment un angle droit, mais peuvent de manière générale former n'importe quel angle.

Le moyen d'aimantation interne d'entrée 11 comprend ou est un solénoïde interne d'entrée 11 entourant une partie de la première partie de la portion 33.

Le moyen 11 créé dans la première partie de la portion 33 un champ magnétique parallèle à Z et à la direction d'élongation de la première partie de la portion 33.

La chambre 2 comprend des moyens pour alimenter électriquement le solénoïde 11 par un courant continu.

Le moyen d'aimantation interne de sortie 12 comprend ou est un ou un groupe 12 d'aimant(s) permanent(s) et/ou de bobine(s) de Helmholtz encadrant une partie de la deuxième partie de la portion 33, et agencé pour émettre un champ magnétique perpendiculaire à la partie de la portion 33 qu'ils encadrent.

Le moyen 12 créé dans la deuxième partie de la portion 33 un champ magnétique parallèle à Z et perpendiculaire à la direction d'élongation de la deuxième partie de la portion 33.

Ainsi, le champ magnétique 6 s'inverse selon la direction Z lorsque le flux de solution 1 parcourt la portion 33.

On note que dans une variante non illustrée de la figure 8, on a :

- la portion 33 non rectiligne
- Le moyen d'aimantation interne d'entrée 11 comprend ou est un ou un groupe 11 d'aimant(s) permanent(s) et/ou de bobine(s) de Helmholtz, encadrant une partie de la première partie de la portion 33, et agencés pour émettre dans la première partie de la portion 33 un champ magnétique perpendiculaire à la partie de la portion 33 qu'ils encadrent,

- Le moyen d'aimantation interne de sortie 12 qui comprend ou est un solénoïde interne de sortie 12 entourant une partie de la deuxième partie de la portion 33 et créant dans la 2ème partie de la portion 33 un champ magnétique parallèle à Z et à la direction d'élongation de la deuxième partie de la portion 33 .

On va maintenant décrire, en référence aux figures 1 et 9, le quatrième mode de réalisation de dispositif d'hyperpolarisation 400 selon l'invention comprenant le quatrième mode de réalisation de chambre d'inversion 2 selon l'invention, et ces modes de réalisation ne seront décrits que pour leurs différences par rapport aux troisièmes mode de réalisation de chambre 2 et de dispositif 300 précédemment décrits.

En référence à la figure 9, on note donc que dans une variante de la figure 8, on a :

- la portion 33 qui est rectiligne
- Le moyen d'aimantation interne d'entrée 11 comprend ou est un ou un groupe 11 d'aimant(s) permanent(s) et/ou de bobine(s) de Helmholtz, encadrant une partie de la première partie de la portion 33, et agencés pour émettre dans la portion 33 un champ magnétique perpendiculaire à la partie de la portion 33 qu'ils encadrent,

- Le moyen d'aimantation interne de sortie 12 qui comprend ou est un ou un groupe 12 d'aimant(s) permanent(s) et/ou de bobine(s) de Helmholtz, encadrant une partie de la deuxième partie de la portion 33, et agencés pour émettre dans la portion 33 un champ magnétique perpendiculaire à la partie de la portion 33 qu'ils encadrent mais de sens opposé au champ du moyen 11.

On remarque en outre que, pour les figures 8 à 10 :

- le dispositif selon l'invention comprend un moyen d'aimantation intermédiaire d'entrée 81 entre l'entrée de la chambre 2 et le (ou l'au moins un) moyen d'aimantation interne 11 (dans le cas de la figure 9, de la figure 10, et de la variante de la figure 8 pour laquelle les moyens 11 et 12 seraient intervertis), et/ou
- le dispositif selon l'invention comprend un moyen d'aimantation intermédiaire de sortie 82 entre la sortie de la chambre 2 et le (ou l'au moins un) moyen d'aimantation interne 12 (dans la cas de la figure 8, de la figure 9, et de la figure 10)

Chacun des moyens 81 et 82 entoure ou encadre ou longe au moins une partie de la portion 33.

Chacun des moyens 81 et 82 comprend un solénoïde.

Le moyen d'aimantation intermédiaire 81 est agencé pour maintenir dans le conduit 3 un champ magnétique intermédiaire d'entrée (constant dans le temps) , parallèle à la direction d'élongation du conduit 3 à travers l'entrée de la chambre 2, entre le champ magnétique du moyen 41 dans le conduit 3 et le champ magnétique du (ou des) moyen(s) 11 dans la portion 33.

Le moyen d'aimantation intermédiaire 82 est agencé pour maintenir dans le conduit 3 un champ magnétique intermédiaire de sortie (constant dans le temps), parallèle à la direction d'élongation du conduit 3 à travers la sortie de la chambre 2, entre le champ magnétique du moyen 42 dans le conduit 3 et le champ magnétique du (ou des) moyen(s) 12 dans la portion 33.

Les moyens 81 et 82 ont pour fonction d'assurer que l'orientation du champ ressenti par les spins est constante. Sans eux, le succès d'un procédé de transfert de polarisation par le dispositif selon l'invention des figures 8, 9 et 10 risquerait de dépendre trop fortement de l'orientation de l'écran 5 dans l'espace et par rapport aux champ magnétiques ambiants.

L'orientation du champ qui change de 90° au cours de l'espace (et donc du temps) n'est pas un problème si ce changement est suffisamment lent (adiabatique). On peut donner comme exemple de condition d'adiabaticité

[Math.6]

$$\frac{d\alpha}{dt} \ll \gamma B(t)$$

Où a est l'angle du champ B(t) au temps t et $\gamma$ est le rapport gyromagnétique le plus faible des deux spins. Comme expression numérique, on peut donc donner :

[Math.7]

$$10\frac{d\alpha}{dt} < \gamma B(t)$$

On remarque qu'aucun des modes de réalisation de dispositif selon l'invention ou de chambre selon l'invention venant d'être décrit en référence aux figures 1 à 10 ne comprend de moyens pour émettre des micro ondes (c'est-à-dire des rayonnements électromagnétiques de fréquence supérieure à 1GHz ou comprise entre 1 GHz et 300 GHz) dans la chambre et/ou dans la portion 2.

On va maintenant décrire, en référence aux figures 1 et 10, le cinquième mode de réalisation de dispositif d'hyperpolarisation 500 selon l'invention comprenant le cinquième mode de réalisation de chambre d'inversion 2 selon l'invention, et ces modes de réalisation ne seront décrits que pour leurs différences par rapport aux premiers mode de réalisation de chambre 2 et de dispositif 100 précédemment décrits.

En référence à la figure 10, on note donc que on peut avoir :

- la portion 33 qui est rectiligne
- Le moyen d'aimantation interne d'entrée 11 comprend ou est un ou un groupe 11 d'aimant(s) permanent(s) et/ou de bobine(s) de Helmholtz, encadrant ou longeant une partie de la première partie de la portion 33, et agencés pour émettre un champ magnétique parallèle à la partie du conduit 33 qu'ils encadrent,

- **Le moyen** d'aimantation interne de sortie 12 qui comprend ou est un ou un groupe 12 d'aimant(s) permanent(s) et/ou de bobine(s) de Helmholtz, encadrant ou longeant une partie de la deuxième partie de la portion 33, et agencés pour émettre un champ magnétique parallèle à la partie du conduit 33 qu'ils encadrent.

On maintenant décrire, en référence aux figures 1 à 10, différents modes de réalisation de procédé selon l'invention mis en œuvre dans les différents modes de réalisation de dispositif d'hyperpolarisation 100, 200, 300, 400, 500 selon l'invention.

Dans tous les dispositifs 100, 200, 300, 400 et 500, le procédé d'hyperpolarisation, comprend une fourniture de la solution 1 à l'état liquide, cette solution 1 comprenant :

o le premier type de spins nucléaires (par exemple des noyaux d'hydrogène $^1$H) ayant un premier rapport gyromagnétique et hyperpolarisés et
o le deuxième type de spins nucléaires (par exemple des noyaux carbone $^{13}$C, azote $^{15}$N, ou phosphore $^{31}$P) ayant un deuxième rapport gyromagnétique et n'étant pas hyperpolarisés;

les spins nucléaires des deux types étant, dans une ou plusieurs molécules de la solution 1, couplés par un couplage de spins scalaire aussi appelé par l'homme du métier « couplage J ». Ce couplage est un couplage persistant (sans échange chimique).

La solution 1 est fournie à la chambre d'inversion 2 de sorte que cette solution 1 s'écoule selon le flux de solution 1 dans le conduit 3 dont la portion appelée portion d'inversion 33 traverse la chambre d'inversion 2.

La chambre d'inversion 2 comprend son entrée par laquelle entre le flux de solution 1 et sa sortie par laquelle sort le flux de solution 1.

La chambre d'inversion 2 comprend l'écran magnétique 5 entourant la portion d'inversion 33 et qui isole la portion d'inversion 33 des champs magnétiques ambiants autour de l'écran magnétique 5.

Dans les dispositifs 100, 200, 300, 400 et 500, le procédé selon l'invention comprend en outre une création dans la portion 33, par l'au moins un moyen d'aimantation situé au moins en partie à l'intérieur de l'écran magnétique 5, dit au moins un moyen d'aimantation interne 11, 12, et entourant ou encadrant ou longeant au moins une partie de la portion d'inversion 33, du champ magnétique d'inversion 6 dont la principale composante est selon la direction Z et s'inverse, de préférence une unique fois, en parcourant l'intérieur de la portion d'inversion 33 de manière à transférer, au sein de la portion d'inversion 33, l'hyperpolarisation du premier type de spins nucléaires vers le deuxième type de spins nucléaires lors de l'écoulement du flux de solution 1 avec une vitesse non nulle de la solution 1 dans la portion d'inversion 33 de l'entrée de la chambre 2 jusqu'à la sortie de la chambre 2, i.e. sans immobiliser la solution 1 dans la portion d'inversion 33. Il s'agit d'un transfert « croisement évité », dont la théorie de Landau-Zener permet de calculer la probabilité.

Comme vu précédemment, la portion d'inversion 33 peut être rectiligne, ou pas.

La composante principale, selon la direction Z, du champ d'inversion 6 peut être perpendiculaire ou parallèle (ou même oblique dans certaines variantes) à la direction du flux de la solution 1 dans la portion 33. La direction Z est constante, la direction du flux de solution 1 dans la portion 33 peut changer, par exemple par des coudes, courbes, ou virages de la portion 33.

Dans le cas du dispositif 100 ou 500 :

- chaque moyen d'aimantation interne 11, 12 produit un champ magnétique constant dans le temps et opposé au champ de l'autre moyen d'aimantation interne, la somme des champs de ces deux moyens d'aimantation internes s'inversant au sein 71, de préférence au centre, de la portion d'inversion 33,
- les deux moyens d'aimantation interne 11, 12 sont alimentés par les courants $i_1$ de sens de rotation opposés et leurs champs de fuite s'opposent.

La solution préférée, pour avoir un profil de champ 6 idéal, est d'utiliser des moyens d'aimantation internes 11 et 12 (ou 110 et 120) symétriques (par rapport à un plan 71 perpendiculaire à la portion 33 qui est de préférence rectiligne) et qui se font face à l'intérieur de l'écran 5 et autour ou le long de la portion 33, comme pour les dispositifs 100, 200 et 500.

Dans le cas du dispositif 200 :

- **les deux** ensembles (110, 120) de solénoïdes internes sont alimentés par les courants $i_1$ de sens de rotation opposés et leurs champs de fuite s'opposent,
- le procédé comprend de manière optionnelle une variation des résistances 23 des ponts diviseurs 20 via l'interface de réglage, de manière à régler ou optimiser le profil d'inversion de champ magnétique d'inversion 6.

Dans le cas du dispositif 100, 200, 300, 400 et 500 :

- la fourniture de la solution 1 à la chambre d'inversion 2 comprend :

  ○ de manière préférentielle une fourniture de la solution 1 en provenance du dispositif (18) de Polarisation dynamique nucléaire DNP, de préférence dDNP, relié au conduit 3, et/ou
  ○ une fourniture de la solution 1 en provenance de tout autre dispositif 18 capable de fabriquer et/ou fournir une solution comprenant les deux types de spins nucléaires,

- le moyen d'aimantation externe respectivement d'entrée 41 ou de sortie 42 maintient dans le conduit 3 respectivement le champ magnétique d'entrée à l'entrée de la chambre d'inversion 2 ou le champ magnétique de sortie à la sortie de la chambre d'inversion 2,
- les deux moyens d'aimantation externe 41, 42 sont alimentés par les courants $i_2$ de sens de rotation opposés,
- le procédé comprend de préférence une purification de la solution 1 par les moyens de purification, par exemple une ou plusieurs matrices polarisantes, en aval de la chambre 2, i.e entre la chambre 2 et le dispositif 19,
- le procédé comprend en outre une fourniture de la solution 1, après son passage dans la chambre d'inversion 2, au spectromètre à résonance magnétique nucléaire (RMN) 19 ou au dispositif d'imagerie par résonance magnétique (IRM) 19 par le conduit 3.

Le procédé peut par exemple comprendre de l'hyperpolarisation de métabolites au $^{13}$C pour la détection du cancer de la prostate par IRM, ou l'hyperpolarisation de métabolites au $^{13}$C (ou autre noyau à bas rapport gyromagnétique couplé à des noyaux de $^1$H) pour le criblage de médicament par résonance magnétique nucléaire (RMN), l'étude de cinétique chimique ou biologique et la métabolomique par RMN, l'interaction protéine / liguant par exemple dans le cadre de criblage de médicaments, etc.

Par exemple, un transfert a été réalisé dans les conditions expérimentales suivantes :

- dispositif d'hyperpolarisation utilisé : dispositif 100

- conduit 3 en amont et en aval de la chambre 2 : un capillaire en teflon de 3,2 mm de diamètre externe et 1,6 mm de diamètre interne (section circulaire) autour duquel était enroulé et collé un fil de cuivre de 0,5 mm (solénoïde 51 ou 52). Un courant de 2 A fourni par une alimentation de laboratoire passait dans fil de cuivre (solénoïde 51 ou 52) produisant un champ magnétique de l'ordre de 4 mT dans le capillaire en amont et en aval de la chambre 2.

- composition de la solution 1 à l'entrée de la chambre 2: un échantillon DNP de 100 μL (composition : 0,43 M $^{13}$C-formate de sodium, 0,44 M [3-$^{13}$C]-pyruvate de sodium, 0,44 M [2-$^{13}$C]-pyruvate de sodium, 0,45 M [1-$^{13}$C]-pyruvate de sodium et 50 mM TEMPOL dissout dans 1:3:6 $H_2O$:$D_2O$:$D_8$-glycerol v/v/v) dont les spins $^1$H ont été hyperpolarisés dans un polariseur 18 dDNP à 1.2 K et 7.05 T. La polarisation $^1$H de l'échantillon avant dissolution était de ≈ 50%. La faible polarisation $^{13}$C de l'échantillon (acquise pendant que les spins $^1$H étaient en train d'être polarisés) a été réduite à 0% par une série d'impulsion radiofréquence avant dissolution (de manière à s'assurer que la polarisation $^{13}$C en liquide après dissolution et transfert provient exclusivement du transfert depuis le $^1$H). L'échantillon a été dissout dans 5 mL de $D_2O$ pressurisé à 6 bar et chauffé jusqu'à atteindre 9 bar et 175 °C puis transféré à l'aide d'un système de transfert et injection rapide (voir par exemple « An automated system for fast transfer and injection of hyperpolarized solutions » de Ceillier et al., Journal of Magnetic Resonance Open Volumes 8-9, December 2021, 100017) en 1,8 s jusqu'à un tube RMN placé dans un spectromètre RMN de paillasse opérant à 1,88 Tesla (référencé 19 sur la figure 1). La vélocité de la solution pendant le transfert était de ≈5 m.s$^{-1}$. Le conduit permettant le transfert de la solution du polariseur jusqu'au spectromètre de paillasse passait par la chambre d'inversion, qui avant été disposée de manière à être au plus près de la sortie du polariseur dDNP (pour minimiser les pertes de polarisation $^1$H).

- tous les solénoïdes 11, 12 sont en fil de cuivre, de diamètre de fil de 0,5 mm, diamètre de spires 12 mm, 112 spires, longueur de solénoïde 7,3 cm, séparé de 10,4 cm et alimentés avec un courant $i_1$ de 0,05 ampères

- tous les solénoïdes 41, 42 sont en fil de cuivre, de diamètre de fil de 0,5 mm, diamètre de spires 1,8 cm, 107 spires, longueur de solénoïde 70 cm et alimentés avec un courant $i_2$ de 1 ampère

- tous les solénoïdes 51, 52 sont en fil de cuivre, de diamètre de fil de 0,5 mm, diamètre de spires 3,2 mm, >2000 spires, longueur de solénoïde >100 cm et alimentés avec un courant de 2 ampères

- le support 8 est en résine imprimée en 3D (clear resine) comprenant une rainure pour placer le fil de cuivre de la manière la précise possible,

- le support 9 est en résine imprimée en 3D (clear resine) comprenant une rainure pour placer le fil de cuivre de la manière la précise possible,

- le conduit 3, 33 est réalisé par un support imprimé en 3D traversé par un trou carré (4 mm de côté) dans lequel passe le capillaire 3,33 (ou conduit) de 3,2 mm de diamètre externe (section circulaire) et 1,6 mm de diamètre interne (section circulaire),

- l'écran 5 est en $\mu$-metal, comprend 4 couches concentriques d'environ 1 mm d'épaisseur, et à une longueur, le long de l'axe S, de 32,6 cm (MS-1L, Twinleaf)

- la distance D, 13 est de 7,3 cm.

Le champ obtenu est illustré en figure 4.

Les polarisations $^{13}$C obtenues à l'état liquide à l'issue de cette expérience pour les quatre molécules présentes dans la solution sont présentées dans le tableau ci-dessous. L'expérience a été répétée deux fois (« Inversion #1 », « Inversion #2 »). En outre, deux expériences de contrôle ont été effectuées :

- Lors de l'expérience « Sans inversion #1 », la solution a traversé la chambre d'inversion mais le bobines avaient été connectées de telle manière que le champ magnétique ne s'inversait pas (il diminuait jusqu'à une valeur de l'ordre du $\mu$T puis remontait)
- Lors de l'expériences « Sans inversion #2 », la solution ne passait pas par la chambre d'inversion.

| | Couplage-J (Hz) | Inversion #1 | Inversion #2 | Sans inversion #1 | Sans inversion #2 |
|---|---|---|---|---|---|
| $^{13}$C-formate | 195 | 9.0% | 12.3% | 1.3% | 1.1% |
| [3-$^{13}$C]-pyruvate | 125 | 11.2% | 10.4% | 3.6% | 3.9% |
| [2-$^{13}$C]-pyruvate | 6.2 | 0 | 0 | 0 | 0 |
| [1-$^{13}$C]-pyruvate | 1.3 | 0 | 0 | 0 | 0 |

Etant donné le profil de champ magnétique de la chambre d'inversion et étant donné la vélocité de la solution, les simulations numériques de dynamique de spins prévoient que le transfert de polarisation du $^{1}$H vers le $^{13}$C doit être total pour les molécules de $^{13}$C-formate et [3-$^{13}$C]- pyruvate. En revanche, le transfert est censé être quasi nul pour les molécules de [2-$^{13}$C]-pyruvate et [1-$^{13}$C]-pyruvate parce que leur couplage J est trop faible (pour le profil de champ donné). Nos résultats expérimentaux vérifient ces prédictions.

Les deux expériences de contrôle montrent qu'il y avait un transfert non nul même sans inversion de champ. Ceci est probablement dû à un transfert par effet Overhauser nucléaire (NOE) en liquide. Ce transfert n'a pas lieu dans les molécules de [2-$^{13}$C]-pyruvate et [1-$^{13}$C]-pyruvate car la distance entre les spins nucléaires de $^{1}$H et $^{13}$C est trop grande.

Un détail d'implémentation du dispositif 200 varie du détail d'implémentation du dispositif 100 en ce que :

- tous les solénoïdes 11, 12 sont en fil de cuivre, de diamètre de fil de 0,5 mm, diamètre de spires 4 cm, 62 spires, longueur de solénoïde 3 cm
- la source de courant 21 fournie, en entrée de l'ensemble des ponts diviseurs de courant 20, un courant I de 4000 $\mu$A pour des pour les molécules de $^{13}$C formate ou 30 $\mu$A pour le 1-13C-pyruvate,
- l'ensemble 110 comprend 12 solénoïdes 11 avec 12 diviseurs de courant 20 (un plus grand nombre que ceux illustrés en figure 6) ,
- l'ensemble 120 comprend 12 solénoïdes 12 avec 12 diviseurs de courant 20 (un plus grand nombre que ceux illustrés en figure 6),
- chaque solénoïde 11 ou 12, associé à son pont 20 diviseur de courant ayant des résistances $R_1$ et $R_2$, est parcouru par un courant $i_1 = I(R_2/(R_1+R_2))$
- Chaque couple R1/R2 est différent de manière à ce que chaque portion de solénoïde 11 ou 12 fournisse le champ optimal 6. Chaque résistance à une valeur réglée par défaut à 1000 Ohm pour $R_2$ et pour $R_1$ à une valeur croissante vers le centre de la portion 33 (valeur croissante pour les ponts 20 de gauche à droite pour l'ensemble 110 et de droite à gauche pour l'ensemble 120). Typiquement chaque résistance $R_1$ a une valeur respective de 4 Ohm, 20 Ohm, 44 Ohm, 70 Ohm, 90 Ohm, 125 Ohm, 166 Ohm, 220 Ohm, 302 Ohm, 454 Ohm, 768 Ohm, 2000 Ohm pour les 12 ponts 20 de gauche à droite pour l'ensemble 110 et pour les 12 ponts 20 de droite à gauche pour l'ensemble 120.

Le procédé selon l'invention est applicable sur une solution 1 comprenant une molécule avec un couplage J telle que [2-$^{13}$C]-pyruvate ou [1-$^{13}$C]-pyruvate.

Le procédé selon l'invention est applicable sur une solution 1 comprenant une molécule avec un fort couplage J ([3-$^{13}$C]-pyruvate, J=125 Hz), ou d'autres molécules plus intéressantes pour les applications in vivo telles que le [2-$^{13}$C]-pyruvate ou [1-$^{13}$C]-pyruvate dont les couplages sont d'environ 1,3 et 6,2 Hz, respectivement, de manière plus efficace avec un écran 5 plus long (de l'ordre de 1m de longueur).

Bien sûr, l'invention n'est pas limitée aux exemples qui viennent d'être décrits et de nombreux aménagements peuvent être apportés à ces exemples sans sortir du cadre de l'invention.

La portion d'inversion 33 peut être de forme quelconque, rectiligne, courbe, ou selon un assemblage de courbe(s) et/ou de droite(s).

Bien entendu, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et modes de réalisation décrits précédemment sont combinables entre eux.

**Revendications**

1. Procédé d'hyperpolarisation, comprenant une fourniture d'une solution (1) à l'état liquide comprenant :

    o un premier type de spins nucléaires ayant un premier rapport gyromagnétique et hyperpolarisés et
    o un deuxième type de spins nucléaires ayant un deuxième rapport gyromagnétique;
    les spins nucléaires des deux types étant, dans une ou plusieurs molécules de la solution (1), couplés par un couplage de spins scalaire,
    la solution (1) étant fournie à une chambre d'inversion (2) de sorte que cette solution (1) s'écoule selon un flux de solution dans un conduit (3) dont une portion appelée portion d'inversion (33) traverse la chambre d'inversion (2);
    la chambre d'inversion (2) comprenant une entrée par laquelle entre le flux de solution et une sortie par laquelle sort le flux de solution ;
    la chambre d'inversion (2) comprenant un écran magnétique (5) entourant la portion d'inversion (33) de manière à isoler la portion d'inversion (33) des champs magnétiques ambiants autour de l'écran magnétique (5) ;

    le procédé comprenant en outre :

    - une création, par au moins un moyen d'aimantation situé au moins en partie à l'intérieur de l'écran magnétique (5), dit au moins un moyen d'aimantation interne (11, 12), d'un champ magnétique d'inversion (6) dont la principale composante est selon une direction Z et s'inverse en parcourant l'intérieur de la portion d'inversion (33) de manière à transférer, au sein de la portion d'inversion (33), l'hyperpolarisation du premier type de spins nucléaires vers le deuxième type de spins nucléaires lors de l'écoulement du flux de solution avec une vitesse non nulle dans la portion d'inversion (33) de l'entrée de la chambre jusqu'à la sortie de la chambre.

2. Procédé selon la revendication 1, **caractérisé en ce que** l'au moins un moyen d'aimantation interne (11, 12) comprend, au moins en partie à l'intérieur de l'écran magnétique (5), une paire de moyens d'aimantation internes (11, 12) entourant ou encadrant ou longeant au moins en partie la portion d'inversion (33), chaque moyen d'aimantation interne (11, 12) produisant un champ magnétique constant dans le temps et opposé au champ de l'autre moyen d'aimantation interne, la somme des champs de ces deux moyens d'aimantations internes s'inversant au sein (71), de préférence au centre, de la portion d'inversion (33).

3. Procédé selon la revendication 1, **caractérisé en ce que** l'au moins un moyen d'aimantation interne (11, 12) comprend, au moins en partie à l'intérieur de l'écran magnétique (5), plusieurs solénoïdes internes (11, 12), entourant au moins en partie la portion d'inversion (33) et reliés par des ponts diviseurs de courant (20), les solénoïdes internes (11, 12) étant séparés en deux ensembles (110, 120) de solénoïdes internes alimentés par des courants de sens de rotation opposés et dont les champs de fuite s'opposent.

4. Procédé selon la revendication 3, **caractérisé en ce qu'**il ne comprend pas d'espace de séparation entre les deux ensembles (110, 120) de solénoïdes internes (11, 12).

**5.** Procédé selon l'une quelconque des revendications 3 à 4, **caractérisé en ce que** les ponts diviseurs de courant (20) comprennent des résistances variables (23) par une interface de réglage, le procédé comprenant une variation des résistances (23) des ponts diviseurs (20) via cette interface de manière à régler ou optimiser le profil d'inversion de champ magnétique d'inversion (6).

**6.** Procédé selon l'une quelconque des revendications précédentes, **caractérisé en ce qu'**il comprend en outre un moyen d'aimantation, dit moyen d'aimantation externe d'entrée (41), au moins en partie à l'extérieur de l'écran magnétique (5) et allant au moins jusqu'à l'entrée de la chambre d'inversion (2) et un moyen d'aimantation, dit moyen d'aimantation externe de sortie (42), au moins en partie à l'extérieur de l'écran magnétique et allant au moins jusqu'à la sortie de la chambre d'inversion (2), chaque moyen d'aimantation externe maintenant dans le conduit (3) un champ magnétique d'entrée à l'entrée de la chambre d'inversion (2) et un champ magnétique de sortie à la sortie de la chambre d'inversion (2).

**7.** Procédé selon la revendication 6, **caractérisé en ce que** chaque moyen d'aimantation externe (41, 42) entoure ou encadre ou longe au moins une partie de l'au moins un moyen d'aimantation interne (11, 12).

**8.** Procédé selon la revendication 6 ou 7, **caractérisé en ce que** chaque moyen d'aimantation externe comprend ou est un solénoïde externe, chaque solénoïde externe (41, 42) étant porté autour du conduit (3), en entourant le conduit (3), par l'intermédiaire d'une pièce de support externe (8) qui :

- du côté du conduit (3), n'est pas en contact du conduit, et
- du côté de chaque solénoïde externe (41, 42), comprend des reliefs agencés pour accueillir et positionner les spires de chaque solénoïdes externes (41, 42).

**9.** Procédé selon l'une quelconque des revendications précédentes, **caractérisé en ce que** l'au moins un moyen d'aimantation interne est au moins un solénoïde interne, chaque solénoïde interne (11, 12) étant porté au moins en partie par la portion d'inversion (33), en entourant au moins en partie la portion d'inversion (33), par l'intermédiaire d'une pièce de support interne (9) qui :

- du côté du conduit (3), est en contact du conduit (3), et
- du côté de chaque solénoïde interne (11, 12), comprend des reliefs agencés pour accueillir et positionner les spires de chaque solénoïde interne (11, 12) le long du conduit (3).

**10.** Procédé selon l'une quelconque des revendications précédentes, **caractérisé en ce que** la fourniture de la solution (1) à la chambre d'inversion (2) comprend une fourniture de la solution (1) en provenance d'un dispositif (18) de Polarisation dynamique nucléaire DNP relié au conduit (3).

**11.** Procédé selon l'une quelconque des revendications précédentes, **caractérisé en ce que** la portion d'inversion (33) et/ou le conduit (3) est un capillaire dont la plus grande dimension, perpendiculairement au flux de solution (1), est inférieure à 5 mm.

**12.** Procédé selon l'une quelconque des revendications précédentes, **caractérisé en ce que**, dans la portion d'inversion (33), le champ magnétique d'inversion (6) est compris, en valeur absolue le long de la direction Z, au moins entre 0 mT et 0,1 mT .

**13.** Dispositif d'hyperpolarisation, comprenant une chambre d'inversion, ladite chambre d'inversion (2), comprenant :

- une entrée agencée pour qu'un flux d'une solution (1) à l'état liquide comprenant :

◦ un premier type de spins nucléaires ayant un premier rapport gyromagnétique et hyperpolarisés et
◦ un deuxième type de spins nucléaires ayant un deuxième rapport gyromagnétique, les spins nucléaires des deux types étant, dans une ou plusieurs molécules de la solution (1), couplés par un couplage de spins scalaire,

entre dans la chambre (2) par cette entrée;
- une sortie agencée pour que le flux de solution (1) sorte de la chambre (2) par cette sortie
l'entrée et la sortie étant agencées pour que cette solution (1) s'écoule selon le flux de solution dans un conduit (3) dont une portion appelée portion d'inversion (33) traverse la chambre d'inversion (2);

la chambre (2) comprenant en outre :

- un écran magnétique (5) entourant la portion d'inversion (33) de manière à isoler la portion d'inversion (33) des champs magnétiques ambiants autour de l'écran magnétique (5) ;
- au moins un moyen d'aimantation situé au moins en partie à l'intérieur de l'écran magnétique (5), dit au moins un moyen d'aimantation interne (11, 12), agencé pour créer un champ magnétique d'inversion (6) dont la principale composante est selon une direction Z et s'inverse en parcourant l'intérieur de la portion d'inversion (33) de manière à transférer, au sein de la portion d'inversion (33), l'hyperpolarisation du premier type de spins nucléaires vers le deuxième type de spins nucléaires lors de l'écoulement du flux de solution avec une vitesse non nulle dans la portion d'inversion (33) de l'entrée de la chambre jusqu'à la sortie de la chambre.

ledit dispositif d'hyperpolarisation comprenant en outre un dispositif (18) agencé pour fournir la solution (1) à l'entrée de la chambre d'inversion (2) par le conduit (3).

14. Dispositif selon la revendication 13, **caractérisé en ce que** le dispositif (18) agencé pour fournir la solution (1) comprend un dispositif (18) de Polarisation dynamique nucléaire DNP relié au conduit (3).


**Patentansprüche**

1. Verfahren zur Hyperpolarisation, umfassend die Bereitstellung einer Lösung (1) in flüssiger Form, umfassend:

◦ eine erste Art von Kernspins mit einem ersten gyromagnetischen Verhältnis, die hyperpolarisiert sind, und
◦ eine zweite Art von Kernspins mit einem zweiten gyromagnetischen Verhältnis;
wobei die Kernspins beider Typen in einem oder mehreren Molekülen der Lösung (1) durch eine skalare Spinkopplung gekoppelt sind,
wobei die Lösung (1) einer Inversionskammer (2) zugeführt wird, so dass diese Lösung (1) gemäß einem Lösungsstrom in einer Leitung (3) fließt, von der ein Abschnitt, der als Inversionsabschnitt (33) bezeichnet wird, durch die Inversionskammer (2) verläuft; wobei die Inversionskammer (2) einen Einlass, durch den der Lösungsstrom eintritt, und einen Auslass, durch den der Lösungsstrom austritt, umfasst;
wobei die Inversionskammer (2) eine magnetische Abschirmung (5) umfasst, die den Inversionsabschnitt (33) so umgibt, dass der Inversionsabschnitt (33) von den umgebenden Magnetfeldern um die magnetische Abschirmung (5) herum isoliert wird;
wobei das Verfahren weiterhin umfasst:

- eine Erzeugung eines Inversionsmagnetfelds (6), dessen Hauptkomponente in Z-Richtung verläuft und sich umkehrt, während es durch das Innere des Inversionsabschnitts (33) läuft, durch wenigstens eine Magnetisierungseinrichtung, die sich wenigstens teilweise innerhalb der magnetischen Abschirmung (5) befindet, genannt wenigstens eine interne Magnetisierungseinrichtung (11, 12), um innerhalb des Inversionsabschnitts (33) die Hyperpolarisation der Kernspins der ersten Art auf die Kernspins der zweiten Art zu übertragen, während der Lösungsstrom mit einer von Null verschiedenen Geschwindigkeit im Inversionsabschnitt (33) vom Kammereinlass zum Kammerauslass fließt.

2. Verfahren gemäß Anspruch 1, **dadurch gekennzeichnet, dass** die wenigstens eine interne Magnetisierungseinrichtung (11, 12) wenigstens teilweise innerhalb der magnetischen Abschirmung (5) ein Paar interner Magnetisierungseinrichtungen (11, 12) umfasst, die den Inversionsabschnitt (33) wenigstens teilweise umgeben oder einrahmen oder entlang demselben verlaufen,
wobei jede interne Magnetisierungseinrichtung (11, 12) ein zeitlich konstantes Magnetfeld erzeugt, das dem Feld der anderen internen Magnetisierungseinrichtung entgegengesetzt ist, wobei sich die Summe der Felder dieser beiden internen Magnetisierungseinrichtungen (71) innerhalb, vorzugsweise in der Mitte, des Inversionsabschnitts (33) umkehrt.

3. Verfahren gemäß Anspruch 1, **dadurch gekennzeichnet, dass** die wenigstens eine interne Magnetisierungseinrichtung (11, 12), wenigstens teilweise innerhalb der magnetischen Abschirmung (5), mehrere interne Spulen (11, 12) umfasst, die den Inversionsabschnitt (33) wenigstens teilweise umgeben und durch Stromteilerbrücken (20) miteinander verbunden sind, wobei die internen Spulen (11, 12) in zwei Gruppen (110, 120) von internen Spulen unterteilt sind, die von Strömen mit entgegengesetzter Drehrichtung gespeist werden und deren Streufelder einander entgegengesetzt sind.

4. Verfahren gemäß Anspruch 3, **dadurch gekennzeichnet, dass** es keinen Trennraum zwischen den beiden Gruppen (110, 120) von internen Spulen (11, 12) aufweist.

5. Verfahren gemäß einem der Ansprüche 3 bis 4, **dadurch gekennzeichnet, dass** die Stromteilerbrücken (20) Widerstände (23) umfassen, die über eine Benutzeroberfläche variiert werden können, wobei das Verfahren eine Variation der Widerstände (23) der Teilerbrücken (20) über diese Benutzeroberfläche umfasst, um das invertierte Magnetfeldprofil (6) einzustellen oder zu optimieren.

6. Verfahren gemäß einem der vorstehenden Ansprüche, **dadurch gekennzeichnet, dass** es weiterhin eine Magnetisierungseinrichtung, die als externe Eingangsmagnetisierungseinrichtung (41) bezeichnet wird und sich wenigstens teilweise außerhalb der magnetischen Abschirmung (5) befindet und sich wenigstens bis zum Einlass der Inversionskammer (2) erstreckt, und eine Magnetisierungseinrichtung, die als externe Ausgangsmagnetisierungseinrichtung (42) bezeichnet wird und sich wenigstens teilweise außerhalb der magnetischen Abschirmung befindet und sich wenigstens bis zum Auslass der Inversionskammer (2) erstreckt, umfasst, wobei jede externe Magnetisierungseinrichtung in der Leitung (3) ein Eingangsmagnetfeld am Einlass der Inversionskammer (2) und ein Ausgangsmagnetfeld am Auslass der Inversionskammer (2) aufrechterhält.

7. Verfahren gemäß Anspruch 6, **dadurch gekennzeichnet, dass** jede externe Magnetisierungseinrichtung (41, 42) wenigstens einen Teil wenigstens einer internen Magnetisierungseinrichtung (11, 12) umgibt, einrahmt oder entlang derselben verläuft.

8. Verfahren gemäß Anspruch 6 oder 7, **dadurch gekennzeichnet, dass** jede externe Magnetisierungseinrichtung eine externe Spule umfasst oder ist, wobei jede externe Spule (41, 42) mittels eines externen Trägerstücks (8) um die Leitung (3) herumgeführt ist, indem sie die Leitung (3) umschließt, wobei das Trägerstück:

   - auf der Seite der Leitung (3) nicht mit der Leitung in Kontakt steht und
   - auf der Seite jeder externen Spule (41, 42) Aussparungen umfasst, die so angeordnet sind, dass sie die Wicklungen der jeweiligen externen Spule (41, 42) aufnehmen und positionieren.

9. Verfahren gemäß einem der vorstehenden Ansprüche, **dadurch gekennzeichnet, dass** die wenigstens eine interne Magnetisierungseinrichtung wenigstens eine interne Spule ist, jede interne Spule (11, 12) wenigstens teilweise von dem Inversionsabschnitt (33) gehalten wird, indem sie den Inversionsabschnitt (33) wenigstens teilweise mittels eines internen Trägerstücks (9) umschließt, welches:

   - auf der Seite der Leitung (3) mit der Leitung (3) in Kontakt steht und
   - auf der Seite jeder internen Spule (11, 12) Aussparungen umfasst, die so angeordnet sind, dass sie die Wicklungen der jeweiligen internen Spule (11, 12) entlang der Leitung (3) aufnehmen und positionieren.

10. Verfahren gemäß einem der vorstehenden Ansprüche, **dadurch gekennzeichnet, dass** die Zufuhr der Lösung (1) in die Inversionskammer (2) die Zufuhr der Lösung (1) aus einer Vorrichtung (18) zur dynamischen Kernspinpolarisation (DNP), die mit der Leitung (3) verbunden ist, umfasst.

11. Verfahren gemäß einem der vorstehenden Ansprüche, **dadurch gekennzeichnet, dass** der Inversionsabschnitt (33) und/oder der Kanal (3) eine Kapillare ist, deren größte Abmessung senkrecht zur Strömungsrichtung der Lösung (1) weniger als 5 mm beträgt.

12. Verfahren gemäß einem der vorstehenden Ansprüche, **dadurch gekennzeichnet, dass** im Inversionsabschnitt (33) das Inversionsmagnetfeld (6) als Absolutwert in Z-Richtung in einem Bereich von wenigstens 0 mT bis 0,1 mT liegt.

13. Hyperpolarisationsvorrichtung, umfassend eine Inversionskammer, wobei die Inversionskammer (2) Folgendes umfasst:

   - einen Einlass, der so angeordnet ist, dass ein Strom einer Lösung (1) im flüssigen Zustand, umfassend:

     ◦ eine erste Art von Kernspins mit einem ersten gyromagnetischen Verhältnis, die hyperpolarisiert sind, und
     ◦ eine zweite Art von Kernspins mit einem zweiten gyromagnetischen Verhältnis, wobei die Kernspins beider Typen in einem oder mehreren Molekülen der Lösung (1) durch eine skalare Spinkopplung gekoppelt sind, durch diesen Einlass in die Kammer (2) eintritt;

- einen Auslass, der so angeordnet ist, dass der Strom der Lösung (1) durch diesen Auslass aus der Kammer (2) austritt,

wobei der Einlass und der Auslass so angeordnet sind, dass diese Lösung (1) gemäß des Lösungsstroms in einer Leitung (3) fließt, von der ein Teil, der als Inversionsabschnitt (33) bezeichnet wird, durch die Inversionskammer (2) hindurch verläuft;

wobei die Kammer (2) weiterhin Folgendes umfasst:

- eine magnetische Abschirmung (5), die den Inversionsabschnitt (33) so umgibt, dass der Inversionsabschnitt (33) von den umgebenden Magnetfeldern um die magnetische Abschirmung (5) herum isoliert wird;
- wenigstens eine Magnetisierungseinrichtung, die sich wenigstens teilweise innerhalb der magnetischen Abschirmung (5) befindet, genannt interne Magnetisierungseinrichtung (11, 12), die so angeordnet ist, dass innerhalb des Inversionsabschnitts (33) ein internes Inversionsmagnetfeld entsteht, dessen Hauptkomponente entlang einer Z-Richtung zeigt und sich umkehrt, indem es das Innere des Inversionsabschnitts (33) durchläuft, so dass es innerhalb des Inversionsabschnitts (33) die Hyperpolarisation der Kernspins der ersten Art auf die Kernspins der zweiten Art überträgt, während der Lösungsstrom mit einer von Null verschiedenen Geschwindigkeit im Inversionsabschnitt (33) vom Kammereinlass zum Kammerauslass fließt,

wobei die Hyperpolarisationsvorrichtung weiterhin eine Vorrichtung (18) umfasst, die so ausgelegt ist, dass sie die Lösung (1) über die Leitung (3) dem Einlass der Inversionskammer (2) zuführt.

**14.** Vorrichtung gemäß Anspruch 13, **dadurch gekennzeichnet, dass** die Vorrichtung (18), die so ausgelegt ist, dass sie die Lösung (1) zuführt, eine mit der Leitung (3) verbundene Vorrichtung (18) zur dynamischen Kernspinpolarisation (DNP) umfasst.

## Claims

**1.** A hyperpolarization method, comprising providing a solution (1) in the liquid state comprising:

- ○ a first type of nuclear spins that are hyperpolarized and with a first gyromagnetic ratio and
- ○ a second type of nuclear spins with a second gyromagnetic ratio;

the nuclear spins of both types being coupled by scalar spin-spin coupling in one or more molecules of solution (1), the solution (1) being supplied to an inversion chamber (2) so that this solution (1) circulates in the form of a solution flow in a conduit (3) of which a portion called the inversion portion (33) passes through the inversion chamber (2); the inversion chamber (2) comprising an inlet through which the solution flow enters and an outlet through which the solution flow exits;

the inversion chamber (2) comprising a magnetic screen (5) which surrounds the inversion portion (33) so as to isolate the inversion portion (33) from ambient magnetic fields around the magnetic screen (5);

the method further comprising:

- creation, by at least one magnetization means located at least partially inside the magnetic screen (5), called at least one internal magnetization means (11, 12), of an inversion magnetic field (6) the main component of which is along a direction Z and inverts as it travels through the inside of the inversion portion (33) so as to transfer, within the inversion portion (33), the hyperpolarization from the first type of nuclear spins to the second type of nuclear spins during a solution flow with non-zero velocity in the inversion portion (33) from the chamber inlet to the chamber outlet.

**2.** The method according to claim 1, **characterized in that** the at least one internal magnetization means (11, 12) comprises, at least partially within the magnetic screen (5), a pair of internal magnetization means (11, 12) at least partially surrounding or framing or skirting the inversion portion (33),

each internal magnetization means (11, 12) producing a magnetic field that is constant over time and is opposite to the field of the other internal magnetization means, the sum of the fields of these two internal magnetization means inverting within (71), preferably at the center of, the inversion portion (33).

3. The method according to claim 1, **characterized in that** the at least one internal magnetization means (11, 12) comprises, at least in part within the magnetic screen (5), multiple internal solenoids (11, 12), at least partially surrounding the inversion portion (33) and connected by current divider bridges (20), the internal solenoids (11, 12) being separated into two assemblies (110, 120) of internal solenoids powered by currents of opposite direction of rotation and whose leakage fields oppose each other.

4. The method according to claim 3, **characterized in that** it does not comprise a gap between the two assemblies (110, 120) of internal solenoids (11, 12).

5. The method according to any one of claims 3 to 4, **characterized in that** the current divider bridges (20) comprise variable resistors (23) via an adjustment interface, the method comprising a variation of the resistors (23) of the divider bridges (20) via this interface so as to adjust or optimize the magnetic field inversion profile (6).

6. The method according to any one of the preceding claims, **characterized in that** it further comprises a magnetization means, called an external inlet magnetization means (41), at least partially outside the magnetic screen (5) and extending at least as far as the inlet of the inversion chamber (2), and a magnetization means, called an external outlet magnetization means (42), at least partially outside the magnetic screen and extending at least as far as the outlet of the inversion chamber (2), each external magnetization means maintaining within the conduit (3) an input magnetic field at the inlet of the inversion chamber (2) and an output magnetic field at the outlet of the inversion chamber (2).

7. The method according to claim 6, **characterized in that** each external magnetization means (41, 42) surrounds or frames or skirts at least part of the at least one internal magnetization means (11, 12).

8. The method according to claim 6 or 7, **characterized in that** each external magnetization means comprises or is an external solenoid, each external solenoid (41, 42) being carried around the conduit (3), surrounding the conduit (3), by means of an external support piece (8) which:

   - on the conduit (3) side, is not in contact with the conduit, and
   - on the side of each external solenoid (41, 42), comprises reliefs arranged to accommodate and position the turns of each external solenoid (41, 42).

9. The method according to any one of the preceding claims, **characterized in that** the at least one internal magnetization means is at least one internal solenoid, each internal solenoid (11, 12) being carried at least in part by the inversion portion (33), surrounding the inversion portion (33) at least in part, via an internal support piece (9) which:

   - on the conduit (3) side, is in contact with the conduit (3), and
   - on the side of each internal solenoid (11, 12), comprises reliefs arranged to accommodate and position the turns of each internal solenoid (11, 12) along the conduit (3).

10. The method according to any of the preceding claims, **characterized in that** supplying the solution (1) to the inversion chamber (2) comprises supplying the solution (1) from a dynamic nuclear polarization DNP device (18) connected to the conduit (3).

11. The method according to any of the preceding claims, **characterized in that** the inversion portion (33) and/or the conduit (3) is a capillary whose largest dimension, perpendicular to the solution flow (1), is less than 5 mm.

12. The method according to any one of the preceding claims, **characterized in that**, in the inversion portion (33), the inversion magnetic field (6) is comprised, in absolute value along the direction Z, at least between 0 mT and 0.1 mT.

13. The hyperpolarization device, comprising an inversion chamber, said inversion chamber (2), comprising:

   - an inlet arranged so that a flow of a solution (1) in the liquid state comprising:

      ∘ a first type of nuclear spins that are hyperpolarized and with a first gyromagnetic ratio and
      ∘ a second type of nuclear spins with a second gyromagnetic ratio, the nuclear spins of both types being coupled by scalar spin-spin coupling in one or more molecules of the solution (1),

enters the chamber (2) through this inlet;

- an outlet arranged so that the solution flow (1) leaves the chamber (2) through this outlet

the inlet and outlet being arranged so that this solution (1) flows according to the solution flow within a conduit (3), a portion of which, called the inversion portion (33), passes through the inversion chamber (2);
the chamber (2) further comprising:

- a magnetic screen (5) surrounding the inversion portion (33) to isolate the inversion portion (33) from ambient magnetic fields around the magnetic screen (5);
- at least one magnetization means located at least partially inside the magnetic screen (5), called at least one internal magnetization means (11, 12), arranged to create an inversion magnetic field (6) the main component of which is along a direction Z and inverts as it travels through the inside of the inversion portion (33) so as to transfer, within the inversion portion (33), the hyperpolarization from the first type of nuclear spins to the second type of nuclear spins during a solution flow with non-zero velocity in the inversion portion (33) from the chamber inlet to the chamber outlet.

said hyperpolarization device further comprising a device (18) arranged to supply the solution (1) to the inlet of the inversion chamber (2) via the conduit (3).

**14.** The device according to claim 13, **characterized in that** the device (18) arranged to supply the solution (1) comprises a dynamic nuclear polarization, or DNP, device (18) connected to the conduit (3).

[Fig. 1]

[Fig. 2]

[Fig. 3]

[Fig. 4]

EP 4 548 114 B1

[Fig. 5]

[Fig. 6]

**[Fig. 7]**

$$I_1 = I \frac{R_2}{R_1 + R_2}$$

[Fig. 8]

EP 4 548 114 B1

33

[Fig. 9]

[Fig. 10]

a)

b)

EP 4 548 114 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 200826937 A

- WO 2013153101 A

**Littérature non-brevet citée dans la description**

- **KONSTANTIN I. et al.** The role of level anti-crossings in nuclear spin hyperpolarization. *Progress in Nuclear Magnetic Resonance Spectroscopy*, 24 June 2024, vol. 81, 1-36

- **DE CEILLIER et al.** An automated system for fast transfer and injection of hyperpolarized solutions. *Journal of Magnetic Resonance Open Volumes*, December 2021, vol. 8-9, 100017